(19)

**Europäisches Patentamt**
**European Patent Office**
**Office européen des brevets**

(11) **EP 4 766 093 A1**

(12) **EUROPEAN PATENT APPLICATION**

(43) Date of publication:
   **24.06.2026   Bulletin 2026/26**

(21) Application number: **25212086.0**

(22) Date of filing: **29.10.2025**

(51) International Patent Classification (IPC):
   **H10D 89/60** (2025.01)

(52) Cooperative Patent Classification (CPC):
   **H10D 89/811;** H10D 89/611

(84) Designated Contracting States:
   **AL AT BE BG CH CY CZ DE DK EE ES FI FR GB
   GR HR HU IE IS IT LI LT LU LV MC ME MK MT NL
   NO PL PT RO RS SE SI SK SM TR**
   Designated Extension States:
   **BA**
   Designated Validation States:
   **GE KH LA MA MD TN**

(30) Priority:   **18.12.2024   US 202418986437**

(71) Applicant: **Intel Corporation**
   **Santa Clara, CA 95052 (US)**

(72) Inventors:
   • **DOMANSKI, Krzysztof**
     **81547 Munich (DE)**
   • **MUDDU, Manhar**
     **520015 Vijayawada (IN)**
   • **DUA, Raj  S.**
     **Newark, 94560 (US)**
   • **KUMAR, Anish K.**
     **Chandler, 85226 (US)**

   • **GROPPO, Emanuele**
     **10585 Berlin (DE)**
   • **ISHFAQ, Umair**
     **81375 Munich (DE)**
   • **KLOTZ, Florian**
     **81547 Munich (DE)**
   • **SREEDHAR, Kushal**
     **Portland, 97229 (US)**
   • **RAI, Krithika Balakrishna**
     **Hillsboro, 97123 (US)**
   • **NAVEEN ASHOK, Fnu**
     **Beaverton, 97007 (US)**
   • **AGARWAL, Ritesh**
     **81543 Munich (DE)**
   • **HEBER, Susanne**
     **80805 Munich (DE)**
   • **DHAKAD, Harshit**
     **560066 Bangalore (IN)**

(74) Representative: **HGF**
   **HGF Limited**
   **4th Floor, 1 City Square**
   **Leeds LS1 2ES (GB)**

(54)   **ELECTROSTATIC DISCHARGE PROTECTION**

(57)   Embodiments herein relate to an electrostatic discharge (ESD) protection circuit which uses transistor technologies such as Ribbon field-effect transistor (FET), nanowire, nanosheet, nanoribbon, Complementary FET (CFET), and other types of gate-all-around (GAA) transistors or bulk-less types of transistors, in place of transistors such as bipolar junction transistors (BJTs) which rely on a body diode. In an example implementation, the ESD protection circuit includes both overvoltage and undervoltage protection for an input-output rail. A discharge path between the input-output rail and a ground rail can be provided in one or more stages, to protect a receiver and/or transmitter coupled to the input-output rail. Other aspects involve an active clipper device, a disable circuit for ESD protection supporting multiple values of a shutdown voltage, and on-die ESD detection during die-to-die assembly.

Fig. 5

**Description**

BACKGROUND

Electrostatic discharge (ESD) can occur in semiconductor devices when a sudden flow of electricity, caused by a difference in electrical potential, is triggered. For example, the device can accumulate static charges and discharge them to other components according to a Charged Device Model (CDM) type of ESD event. The discharge is typically through conductive pins or terminals. It represents one of the primary ESD failure mechanisms in semiconductor devices, especially during manufacturing, testing, or handling.

BRIEF DESCRIPTION OF THE DRAWINGS

The embodiments of the disclosure will be understood more fully from the detailed description given below and from the accompanying drawings of various embodiments of the disclosure, which, however, should not be taken to limit the disclosure to the specific embodiments, but are for explanation and understanding only.

FIG. 1 depicts an example semiconductor device 100 which includes a package 110 mounted to a substrate 150, where an ESD event can occur at a pad of the package in accordance with various embodiments.

FIG. 2 depicts an example circuit 200 in the package 110 of FIG. 1, including electrostatic discharge (ESD) circuits 210 and 220 for handling positive and negative ESD events, respectively, using bipolar junction transistors (BJTs), in accordance with various embodiments.

FIG. 3A depicts a cross-sectional view in a y-z plane of an example Ribbon field-effect transistor (RibbonFET) 300, in accordance with various embodiments.

FIG. 3B depicts a cross-sectional view in an x-z plane of the RibbonFET 300 of FIG. 3A along the line 301, in accordance with various embodiments.

FIG. 4A depicts a cross-sectional view in a y-z plane of an example complementary field-effect transistor (CFET) device 400, including an n-channel Metal-Oxide-Semiconductor Field-Effect Transistor (MOSFET) TN above a p-channel MOSFET TP, in accordance with various embodiments.

FIG. 4B depicts a cross-sectional view in an x-z plane of the CFET device 400 of FIG. 4A along the line 401, in accordance with various embodiments.

FIG. 5 depicts an example circuit 500 including details of a single-stage ESD circuit 510 for handling an overvoltage ESD event, in accordance with various embodiments.

FIG. 6 depicts an example circuit 600 including details of a two-stage ESD circuit for handling an overvoltage ESD event in accordance with various embodiments.

FIG. 7 depicts plots of current and voltage in the circuits of FIGs. 5 and 6, indicating how a pad voltage is clamped when an overvoltage ESD event occurs, in accordance with various embodiments.

FIG. 8 depicts plots of current and voltage in the circuits of FIGs. 5 and 6, indicating how the ESD circuit is not triggered when a pad voltage toggles, in accordance with various embodiments.

FIG. 9 depicts an example circuit 900 corresponding to the circuit 500 of FIG. 5 and including details of the ESD circuit 530 for handling an undervoltage ESD event, in accordance with various embodiments.

FIG. 10 depicts an example circuit 1000 including details of a two-stage ESD circuit for handling a negative ESD event, in accordance with various embodiments.

FIG. 11 depicts plots of current and voltage in the circuits of FIGs. 9 and 10, indicating how a pad voltage is clamped when a positive ESD event occurs, in accordance with various embodiments.

FIG. 12 depicts plots of current and voltage in the circuits of FIGs. 9 and 10, indicating how the ESD circuit is not triggered when a pad voltage toggles, in accordance with various embodiments.

FIG. 13 depicts an example ESD circuit 1300 based on diode protection, in accordance with various embodiments.

FIG. 14 depicts an example ESD circuit 1400 including a clipper circuit 1410, in accordance with various embodiments.

FIG. 15 depicts another example ESD circuit 1500 including a clipper circuit 1510, in accordance with various embodiments.

FIG. 16 depicts another example ESD circuit 1600 including a clipper circuit 1610, in accordance with various embodiments.

FIG. 17 depicts another example ESD circuit 1700 including a clipper circuit 1710, in accordance with various embodiments.

FIG. 18 depicts a power-up sequence of a power clamp with a disable circuit supplied by an always-on signal Vsd for a gated power supply Vdd_esd, in accordance with various embodiments.

FIG. 19 depicts a block diagram 1900 of a power clamp 1920 with a disable circuit 1910 activated by a single value of Vsd, in accordance with various embodiments.

FIG. 20 depicts a block diagram 2000 of the power clamp 1920 with a disable circuit 2005 activated by multiple values of Vsd, in accordance with various embodiments.

FIG. 21A depicts a disable circuit 2100 for a gated ESD power clamp with three disable pins, in accordance with various embodiments.

FIG. 21B depicts an example implementation of the voltage-drop circuit 2110 of FIG. 21A, in accordance with various embodiments.

FIG. 22 depicts a disable circuit 2200 for a gated ESD power clamp with two disable pins, in accordance with various embodiments.

FIG. 23 depicts plots of voltage and current versus time in a charge device model (CDM) discharge simulation of the power clamp of FIG. 21A, in accordance with various embodiments.

FIG. 24 depicts plots of voltage and current versus time during an inrush current in the power clamp of FIG. 21A, in accordance with various embodiments.

FIG. 25 depicts an example ESD circuit 2500 to detect an ESD event during die-to-die bonding, in accordance with various embodiments.

FIG. 26 depicts an example implementation of multiple detections circuits with different characteristics, including the detection circuit 2510 of FIG. 25 and an additional ESD detection circuit 2610, in accordance with various embodiments.

FIG. 27 depicts an example block diagram showing the placement of an ESD detection circuit in a top-down view of a die 2700, in accordance with various embodiments.

FIG. 28 depicts another example ESD circuit 2800 to detect an ESD event during die-to-die (D2D) bonding, where the fuse branch 2863 of the detection circuit 2810 includes a p-type transistor T285, in accordance with various embodiments.

FIG. 29 depicts plots of current versus time for the fuse 2564 of FIG. 25, in accordance with various embodiments.

FIG. 30 depicts a diagram showing a keep-out zone 3000 for the fuse 2564 of FIG. 25 to prevent shorting with other nearby metals during overheating/filamentation, in accordance with various embodiments.

FIG. 31 illustrates an example of components that may be present in a computing system 3150 for implementing the techniques (e.g., operations, processes, methods, and methodologies) described herein.

DETAILED DESCRIPTION

As mentioned at the outset, an ESD event can result in the failure of a circuit if it is not properly handled.

I. ESD PROTECTION FOR FAIL-SAFE INPUT/OUTPUT (IO) PAD FOR OVERVOLTAGE AND UNDERVOLTAGE PROTECTION

An ESD event can include an overvoltage or an undervoltage, where the voltage at the input/output pad of a circuit suddenly increases or decreases, respectively, relative to a ground path, for instance. In one type of overvoltage, referred to as a pad-to-Vdd (PD) strike, the voltage at the pad is elevated and a current flows from an input-output (I/O) rail of the circuit to a ground (Vss) rail. In one type of undervoltage, referred to as a pad-to-Vss (PS) strike, the voltage at the Vss node is lowered with respect to Vss and a current flows from the ground (Vss) rail to the I/O rail.

In some cases, a circuit has a fail-safe input/output (I/O) interface that can operate with the supply voltage, Vdd, tied to Vss, in power down. The interface is used in systems where the I/O voltage can toggle before the Vdd supply at the pad is activated. The signal at the I/O interface can be used to generate bias voltages in the pad itself. The I/O interfaces are specified for over/under voltage at the pad when the supply is powered down. However, ESD protection for fail-safe interfaces is constrained in terms of leakage budget at the I/O pad, the capacitive load of the ESD protection and the maximum signal voltage tolerated in fail-safe situations.

In some ESD solutions, a body diode is used to provide a current shunt which protects a potential victim circuit during an ESD event.

However, previous approaches for ESD protection of an I/O interface cannot be used with some newer types of transistor technologies such as Ribbon field-effect transistor (FET), nanowire, nanosheet, nanoribbon, Complementary FET (CFET), and other types of gate-all-around (GAA) transistors or bulk-less types of transistors. A GAA transistor has a gate surrounding the channel from all sides. A RibbonFET can include a channel formed by a stack of very thin, ribbon-shaped semiconductor sheets. A nanowire is a type of FET where the conducting channel is made from a very thin, cylindrical nanowire. A nanosheet is a type of FET where the channel is made from a single ribbon-like structure at the nanoscale, e.g., materials such as graphene. A CFET device is a type of semiconductor device that stacks n-type and p-type transistors atop one another in a single, integrated process. Two or more transistors can be stacked atop one another. For example, in the newer types of transistor technologies, a body diode is not available due to the architecture of ribbons that are processed on an insulating substrate.

The solutions provided herein address the above and other disadvantages. The solutions provide ESD protection which are compatible with bulk-less types of transistor technologies. The circuit may use, e.g., FETs such as RibbonFETs, nanowire, nanosheet, nanoribbon, CFET and other types of gate-all-around (GAA) transistors or bulk-less types of transistors.

In an example implementation, an ESD protection circuit includes both overvoltage and undervoltage protection.

In an example implementation, an ESD protection circuit includes overvoltage protection in a single stage or two stages, and undervoltage protection in a single stage or two stages.

The solutions provide a number of advantages, including compatibility with bulk-less types of transistors.

In one aspect, the solutions can provide ESD protection for I/O pads with a fail-safe requirement in the Ribbon-FET process, or other FET or GAA processes.

In one aspect, the solutions provide an ESD circuit in which the clamping voltage, leakage and capacitance can be programmed by resizing or stacking of a pass device.

In one aspect, the solutions provide an ESD circuit which does not rely on parasitic bipolar junction transistors (BJTs).

These and other features will be further apparent in view of the following discussion.

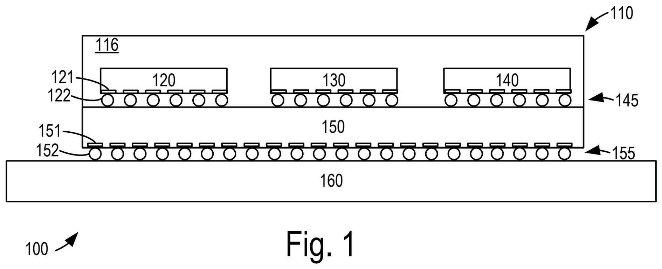

FIG. 1 depicts an example semiconductor device 100 which includes a package 110 mounted to a substrate 150, where an ESD event can occur at a pad of the package in accordance with various embodiments. In this example, the package includes a number of die 120, 130 and 140 such as chiplets, mounted to a package substrate 150 such as by using ball grid arrays 145, for example, where each ball is depicted by a circle. Each die can have pads which contact a respective ball to provide a conductive path for power and/or signals. For example, the die 120 includes a pad 121 which contacts a ball 122. The die may be encapsulated in an insulating material 116. Conductive paths, not shown, can extend between the ball grid array 145 and circuits in the die 120, 130 and 140.

The package substrate 150 in turn may be mounted to a printed circuit board (PCB) 160, also using a ball grid array 155, in an example implementation. Conductive paths, not shown, can extend between the ball grid arrays 145 and 155, and in the PCB. The package substrate can have pads which contact a respective ball on the PCB to provide a conductive path for power and/or signals. For example, the package substrate 150 includes a pad 151 which contacts a ball 152.

The collection of chiplets in the package may be referred to as a system-in-package (SiP). This is merely one example configuration. Alternatives to a ball grid array include a pin grid array and other type of interconnects.

An example ESD event involves an overvoltage or undervoltage condition at one of the pads such as the pad 151, e.g., a fail-safe I/O pad.

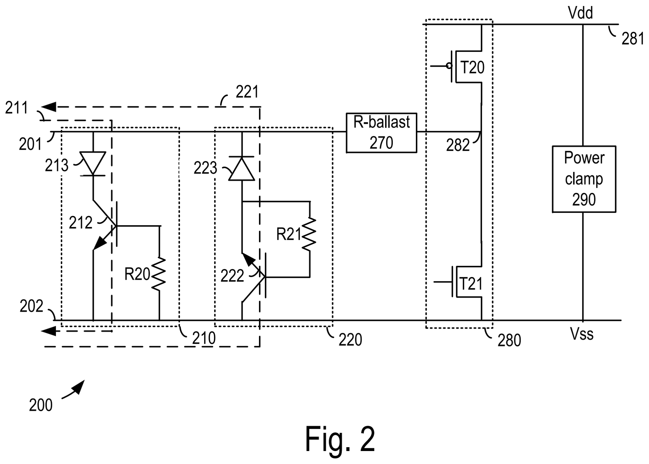

FIG. 2 depicts an example circuit 200 in the package 110 of FIG. 1, including electrostatic discharge (ESD) circuits 210 and 220 for handling positive and negative ESD events, respectively, using bipolar junction transistors (BJTs), in accordance with various embodiments. The circuit 200 includes an I/O rail 201 (or node) and a ground rail 202 (or node). The I/O rail 201 may be coupled to the fail-safe I/O pad on one side and to a transmitter and/or receiver on the other side. A transmitter can transmit or output signals via the I/O rail 201 and a receiver can receive or input signals via the I/O rail 201. These signals may be digital signals, for example. The voltage on the I/O rail 201 thus has an associated voltage corresponding to I/O signals. The ground rail may also be coupled to a respective pad. In an overvoltage ESD event, a positive current flows in a path 211 from the I/O rail to the ground rail. In an undervoltage ESD event, a negative current flows in a path 221 from the ground rail to the I/O rail. When there is no ESD event, the victim circuit 280 as a transmitter transmits data on the I/O rail 201.

The fail-safe I/O pad may be a dedicated electrical connection on the chip package that is designed to automatically trigger a safe state or action in the circuit 200 if a critical failure occurs, such as an ESD event, preventing potential damage to the chip or system by putting it into a known, controlled state.

The circuit 200 further includes a resistance ballast (R-ballast) 270, which is a resistor used to limit the current flowing through the I/O rail to a victim circuit 280. The victim circuit is any type of circuit which is to be protected from ESD damage. The victim circuit is arranged between a power supply rail 281 and the ground rail 202 and includes a transmitter (Tx) as shown here by a pMOS transistor T20 and an nMOS transistor T21 in series. The I/O rail 201 is coupled to a node 282 which is between T20 and T21. A power clamp 290 also extends between the power supply rail 281 and the ground rail 202.

The ESD circuit 210 includes a diode 213 coupled to a npn device 212, between the I/O rail 201 and the ground rail 202. A resistor R20 is coupled at one side to the npn device 212, and at the other side to the ground rail.

The ESD circuit/circuit 220 includes a diode 223 coupled to a npn device 222, between the I/O rail 201 and the ground rail 202. A resistor R21 is coupled at one side to a node between diode and the npn device, and at the other side to the ground rail.

The npn device can be a parasitic npn device in a ballasted n-channel FET, for example. Under a negative charge device model (CDM) stress, there is an overvoltage, and the positive current (path 211) is shunted by the npn device 212. The positive current is forced into the pad and is discharged towards Vss via one or more diodes 213 and the breakdown npn device 212.

Under a positive CDM stress, there is an undervoltage, and the negative current (path 221) is shunted by the npn device 222. The negative current is discharged towards the I/O rail 201 via the breakdown npn device 222 and one or more diodes 223. In this case, during the ESD stress, the pad is drawn below the Vss potential, e.g., the potential of the ground rail 202. The ground rail thus becomes a virtual supply. The ESD current flows through the forward-biased n+/iso-p-well diode and stacked npn breakdown element.

The npn device can be a breakdown npn device such as a BJT or a Silicon Controlled Rectifier (SCR). The breakdown element can thus be realized either as an explicit npn bipolar transistor or an implicit parasitic npn device involved in, e.g., an n-channel driver.

The diodes 213 and 223 can be a single diode or stacked diodes. The diode 213 can be a p+/n-well diode, and the diode 223 can be an n+/iso-p-well diode.

For simplicity, the victim circuit 280 (a Tx driver) is shown as single-stage ballasted n-channel/p-channel device. In planar technologies, the body diodes usually provide a residual current shunt and protect the driver (e.g., a Tx/Rx) by dropping voltage over the R-ballast 270.

The ESD solution of FIG. 2 thus relies on parasitic bipolar elements, in some cases combined with stacked bipolar diodes. The BJT can be realized as an explicit or implicit npn or pnp device. In the drivers, the parasitic junctions inherent to n-channel or p-channel transistors to bulk are utilized in ESD circuits.

The ESD solution of FIG. 2 is not compatible with newer transistor technologies. For example, in a GAA process, the body diode might be not available due to the architecture of ribbons that are processed on an insulating substrate. The solutions provided herein enable fail-safe features for I/O pads to protect against ESD events.

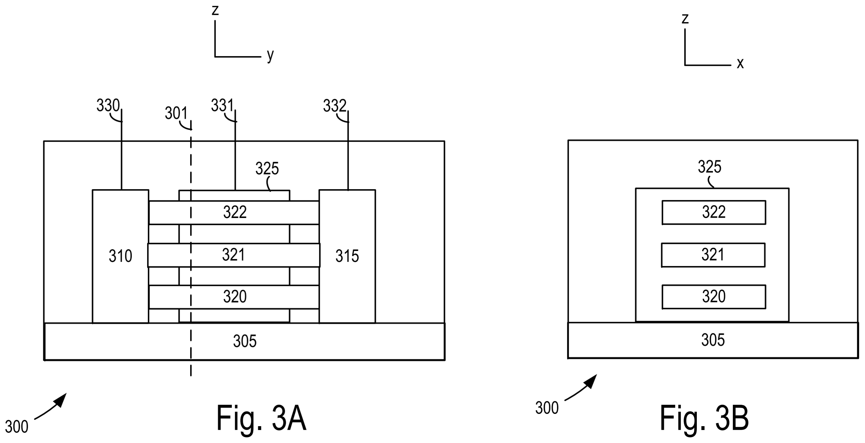

FIG. 3A depicts a cross-sectional view in a y-z plane of an example Ribbon field-effect transistor (RibbonFET) 300, in accordance with various embodiments. The transistor is formed on a substrate 305 and includes source/drain regions 310 and 315, ribbons 320, 321 and 322 which extend between the source/drain regions, and a gate 325 which extends around the ribbons. The source/drain regions can comprise doped silicon, silicon germanium or silicon carbide in some applications, the gate can comprise metal, and the ribbons can comprise silicon and silicon germanium or other materials, for instance. The gate is not limited to the metal, but to the full gate stack (including, e.g., high-k dielectric, work function metal, gate metal). When an appropriate gate voltage is applied, channels can be formed as conductive regions in the channels between the opposing source/drain regions.

Example interconnects 330, 331 and 332 are coupled to the source/drain region 310, the gate 325 and the source/drain region 315, respectively. The interconnects may extend upward to top metal layers to allow connections to other transistors and/or within the same transistor. In another option, interconnects are provided by bottom metal layers which are below the substrate.

FIG. 3B depicts a cross-sectional view in an x-z plane of the RibbonFET 300 of FIG. 3A along the line 301, in accordance with various embodiments. This view shows the ribbons 320-322 and the gate 325.

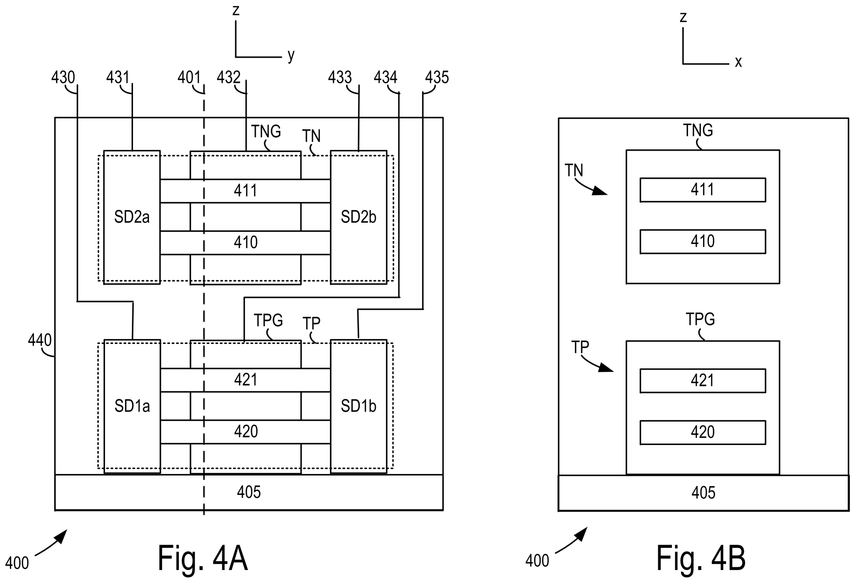

FIG. 4A depicts a cross-sectional view in a y-z plane of an example complementary field-effect transistor (CFET) device 400, including an n-channel MOSFET TN above a p-channel MOSFET TP, in accordance with various embodiments. Alternatively, the positions of the transistors can be reversed. The CFET device is formed on a substrate 405. The nMOS TN includes source/drain nodes SD2a and SD2b, a gate TNG and one or more ribbons 410 and 411 of p-type silicon which extend between the source/drain nodes. The source, drain and gate are terminals of a transistor. The gate TNG extends all around the ribbons, which can form respective conductive channels between the source and the drain when the control gate voltage is sufficiently high. The pMOS TP includes source/drain nodes SD1a and SD1b, a gate TPG and one or more ribbons 420 and 421 of n-type silicon which extend between the source/drain nodes. The gate TPG extends all around the ribbons, which can form respective conductive channels between the source and the drain when the control gate voltage is sufficiently low.

The gate material can be, e.g., any known metal gate material, such as TiN, TiAl, or TiC. The ribbons can be, e.g., nanosheet channels which are fabricated from thin, alternating layers of silicon and silicon germanium. In one approach, a silicon-silicon germanium superlattice is used during the nanosheet fabrication process, where the germanium is only sacrificial and is not present in the final structure. The source/drain terminals can be lightly doped silicon including epitaxial silicon.

The CFET device includes conductive paths, e.g., interconnects, which extend upward from the terminals to the top metal layer for routing. In one approach, the vertical portions of the paths (z-direction) are vias such as metal plated through-vias, for example, or other conductive material. The horizontal (y-direction) portions of the paths can be a conductive silicon, for instance such as polysilicon. The conductive paths can be coupled to contacts of the source/drain terminals. For example, the conductive paths 430, 431, 433 and 435 are coupled to SD1a, SD2a, SD2b and SD1b, respectively. The conductive paths 432 and 434 can be coupled directly to TNG and TPG, respectively, in one approach. The transistors TN and TP can be embedded in a dielectric material 440.

In another option, the interconnects include bottom metal layers. Interconnects contained within the CFET device are also possible. The interconnects allow connections to other CFET devices/transistors and/or between terminals within the same CFET device/transistor.

In another option, more than two transistors are stacked one atop the other in a CFET device. For example, four transistors can be stacked, e.g., two p-type and two n-type.

FIG. 4B depicts a cross-sectional view in an x-z plane of the CFET device 400 of FIG. 4A along the line 401, in accordance with various embodiments. This view shows the ribbons 410 and 411 of TN and the ribbons 420 and 421 of TP.

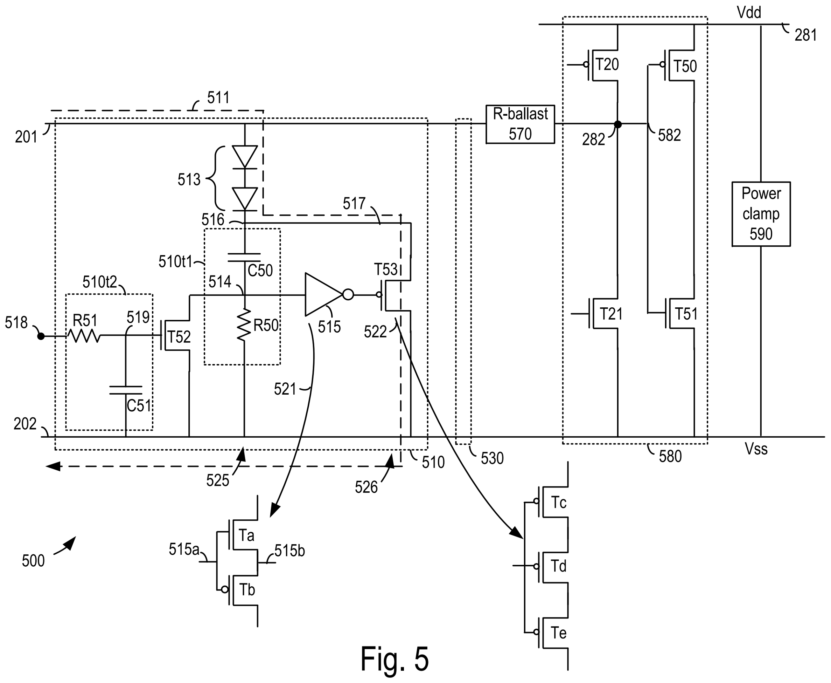

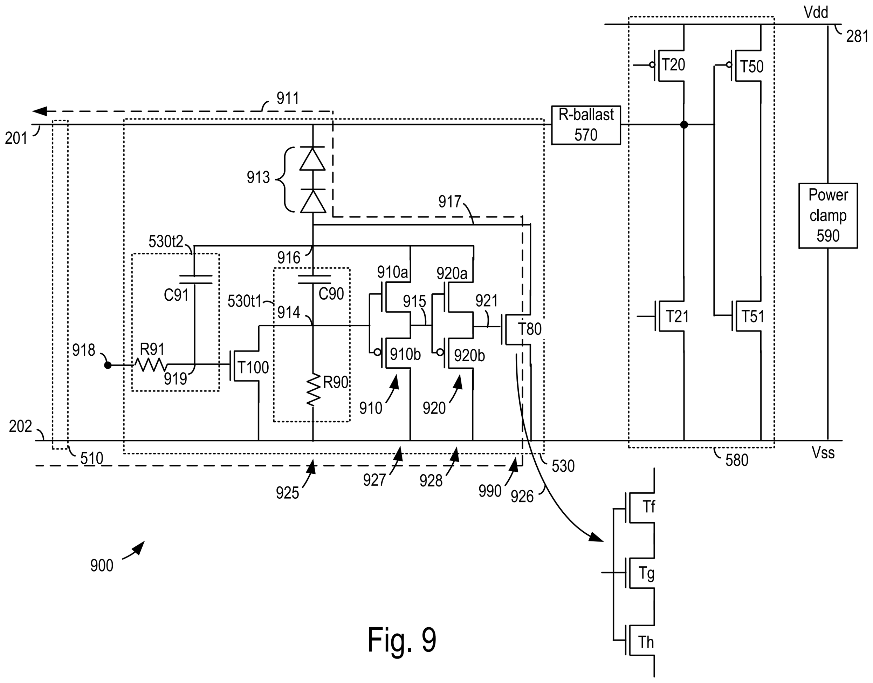

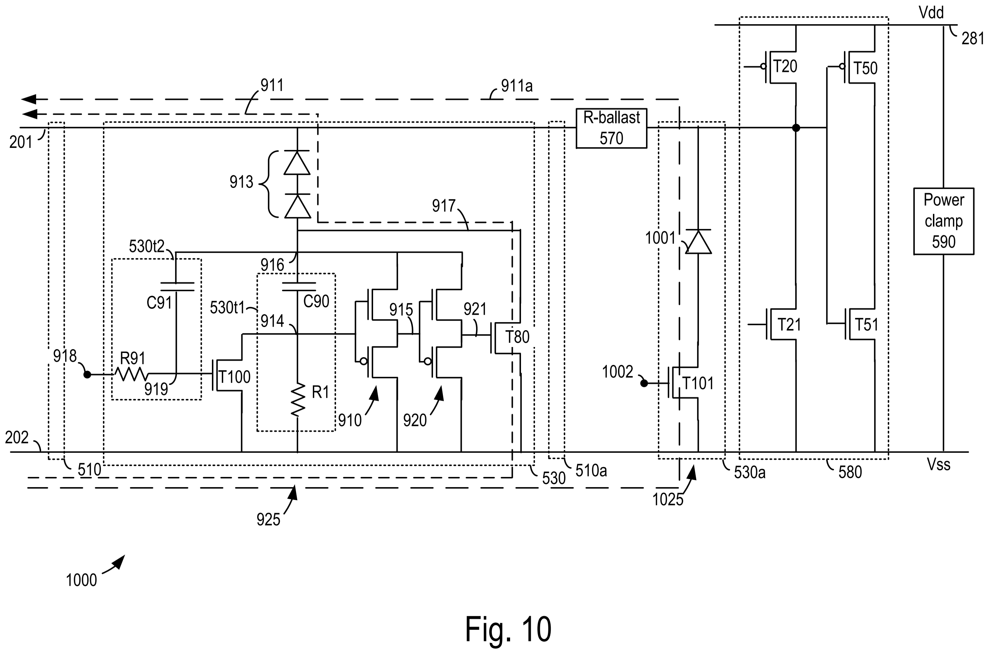

FIG. 5 depicts an example circuit 500 including details of a single-stage ESD circuit 510 for handling an overvoltage ESD event, in accordance with various embodiments. The circuit includes the I/O rail 201, the power supply rail 281 and the ground rail 202 of FIG. 2. The circuit 510 is for handling an overvoltage, and the circuit 530, discussed below in connection with FIGs. 9 and 10, is for handling an undervoltage. In another option, just the overvoltage circuit or just the undervoltage circuit is provided.

The circuit 510 includes one or more diodes 513 in a stacked/series configuration, a capacitor C50, and a resistor R50 in a series path 525 between the rails 201 and 202. Multiple diodes can help reduce leakage current. The diodes can comprise diode-connected transistors in which the gate and drain terminals of each transistor are shorted, for example. Or, the diodes can be standard diodes, e.g., basic p-n junction diodes. A voltage at a node 514, which is between R50 and C50, is coupled to the input of an inverter 515. The output of the inverter 515 is coupled to the gate of a p-type MOSFET T53. The diodes 513 and T53 are in series in a path 526. When T53 is conducting, a current path 517 is created from PAD to the ground rail. The path 517 is also coupled to a node 516 which is between the diodes 513 and R50. The paths 525 and 526 overlap in that they share the diodes 513.

The node 514 is coupled to the ground rail via R50 and via an n-type MOSFET T52. The gate of T52 is coupled to a node 518, which is a Vsd disable node (Vshutdown), via a resistor R51. A node 519 which is between R51 and T52 is coupled to the ground rail via a capacitor C51. The node 518 is coupled to R51 and to an always-on supply voltage. Vsd is the voltage of an SD pin which is attached to an always-on supply.

R50 and C50 are part of a first resistor-capacitor (RC) timer 510t1, and R51 and C51 are part of a second RC timer 510t2.

The arrow 521 indicates the inverter 515 can be formed by a circuit which includes an n-type MOSFET Ta and a p-type MOSFET Tb. The input 515a of the inverter is coupled to the gates of Ta and Tb and to the node 514, and the output 515b of the inverter is coupled to a node between Ta and Tb, and to the gate of T53.

The arrow 522 indicates that the transistor T53 may alternately comprise multiple transistors in series, such as Tc, Td and Te. The stacked pass devices/transistors can reduce leakage current.

During an overvoltage event, also referred to as a negative CDM zap, a current flows in a path 511 from the I/O rail 201, through the diodes 513 and T53 to rail 202.

The victim circuit 580 in this example includes a transmitter (transistors T20 and T21 in series) and a receiver (transistors T50 and T51 in series with connected gates, e.g., an inverter). Additional circuitry, not shown, may be coupled to the Tx and Rx. The Tx transmits a signal via the I/O rail 201, and the Rx receives a signal via the I/O rail 201.

The I/O rail 201 is coupled to the node 282 as discussed and to a node 582 which is coupled to the gates of T50 and T51. A power clamp 590 also extends between the power supply rail 281 and the ground rail 202.

The ESD circuit 510 is used for shunting ESD current for an overvoltage-tolerant pad and can be realized with newer-technology transistors such as bulk-less GAA transistors. In such transistors, there is no galvanic connection to bulk for the n-channel or p-channel device. Thus, the ESD clamping element at the pad is realized by using available process features such as n-channel/p-channel devices, resistors and diodes.

The specification of the ESD circuit 510 can be similar to the corresponding ESD circuit 210 which is realized with an older-technology planar process. As an example, the leakage of the ESD circuit 510 can be specified as being, e.g., <100 uA at maximal signal swing. The ESD clamping voltage should be kept below the breakdown voltage of the victim circuit, e.g., <3-5 V.

The high current path in the ESD circuit 510 can comprise at least one diode stacked with an n-channel or p-channel pass device, e.g., T53.

The pass device is controlled by a driver, e.g., inverter 515, and the first RC timer 510t1. The timer 510t1 opens the gate of the pass device (e.g., turning on/making conductive T53) via the inverter 515 when an overvoltage at its terminal (node 514) is detected. A high voltage at node 514, the input of the inverter 515, results in a low voltage at the output of the inverter and the gate of the p-type transistor T53, (e.g., pMOSFET), turning it on. Before the ESD event, during normal operations, the node 514 is coupled to the ground rail via T52 so that the input of the inverter is low, the output of the inverter is high and T53 is off. During an ESD overvoltage event, the voltage at the node 514 increases, causing the inverter output to decrease and turn on T53. The always-on voltage at the node 518 may begin floating. Since the signal toggling at the I/O can have slew rates in the nanosecond regime (corresponding to 1-5GHz), it can potentially trigger the pass device. Note that the harmonics of a CDM discharge waveform have similar frequency components.

A shut down circuit is introduced to keep the pass device T53 off during normal operations. It includes T52 as a pull-down transistor and the second timer 510t2. The second timer should be connected to an always-on supply before the I/O starts toggling, to disable the first timer 510t1 for the pass device T53.

The construction of timers is not limited to the topology depicted. Other topologies can be used which provide the functionality of turning on a pass device when an ESD event is detected and turning off the pass device at other times during normal operations.

Moreover, the ESD protection can be provided for any topology of victim circuit. In FIG. 5, an exemplary ESD victim circuit includes Rx and/or Tx inverters. Additionally, the victim can be ballasted via the resistor 570 or not. The resistor is in series with the I/O rail 201.

For undervoltage protection, the ESD discharge current path for negative current at the pad can be realized as discussed below, e.g., in connection with FIGs. 9 and 10. In this case, the ESD circuit 510 remains off since the diodes 513 in series with the pass device T53, in the path 526, are reverse biased.

The functionality of an ESD circuit for a fail-safe pad with an undervoltage specification of, e.g., <-0.3 V, is discussed further below.

Generally, the ESD solutions can be implemented in many different circuit configurations, depending on Key Performance Indicators (KPI) for a given fail-safe I/O circuit. The KPIs can include capacitive load, pad leakage, ESD clamping voltage, determined by the protected victim breakdown voltage, pad overvoltage and/or undervoltage requirements, and area and aspect ratio constraints.

For example, to optimize the ESD circuit 510 for reduced leakage, more than one diode can be stacked stack in series with a pass device to reduce the source-drain voltage drop in the pass device. Additionally, the pass device itself can include multiple, e.g., three, stacked n-channel devices in a shared diffusion configuration. The configuration reduces leakage due to a 3x increase of the gate length, assuming the transistors Tc, Td and Te are each the same size as T53.

In the embodiment of FIG. 5, the pad is specified for overvoltage in the fail-safe mode. The reverse diode provides undervoltage tolerance until about -0.3 V of forward biasing of the diode. The embodiment can be extended to include an undervoltage tolerant solution as discussed further below.

Generally, both overvoltage and undervoltage protection can be provided, or if desired, just one type of protection can be provided.

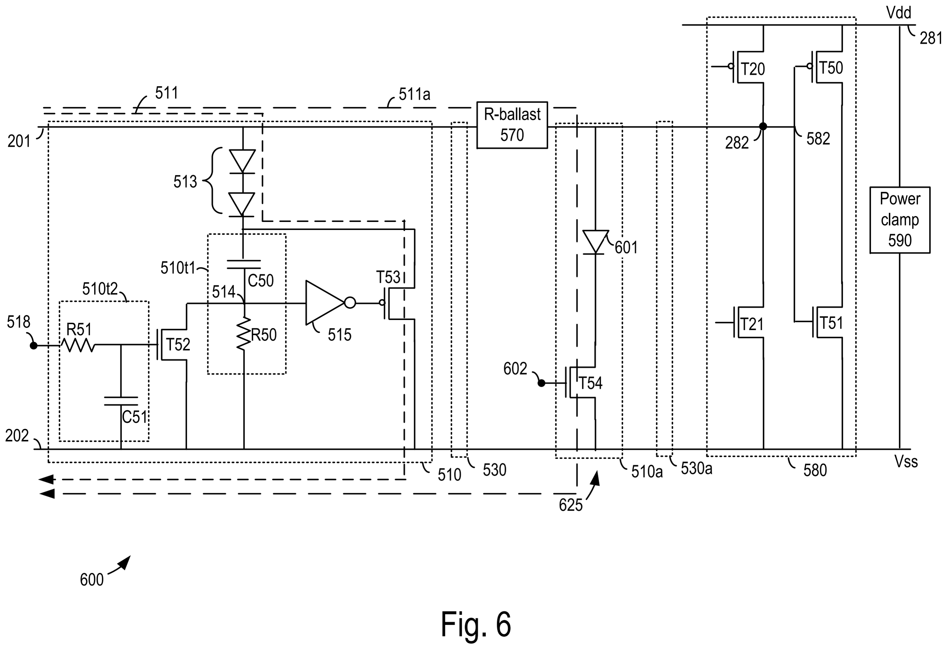

FIG. 6 depicts an example circuit 600 including details of a two-stage ESD circuit for handling an overvoltage ESD event in accordance with various embodiments. The circuit 600 includes the ESD circuit 510 of FIG. 5 as a first stage of a two-stage ESD overvoltage circuit, in addition to a second stage 510a of the two-stage ESD overvoltage circuit. The second stage includes in a series path 625, a diode 601 and an n-type transistor T54 (e.g., nMOSFET) having a node 602 coupled to a gate control voltage. For example, a control circuit may be used to provide the gate control voltage. The node 602 can be coupled to the node 518, for example, so that T52 and T54 are commonly controlled.

The second stage 510a allows an additional current to flow in a path 511a which extends from the I/O rail 201 through the diode 601 and T54 to the rail 202. In an example implementation, the current in the second stage is less than the current in the first stage.

The circuit 600 further includes the ESD circuit 530 of FIG. 5 as a first stage of a two-stage ESD undervoltage circuit, in addition to a second stage 530a (see FIG. 10) of the two-stage ESD undervoltage circuit. The ESD circuit 530 is discussed further in connection with FIGs. 9 and 10, as mentioned.

In general, two or more stages can be used for each of the ESD overvoltage circuit and the ESD undervoltage circuit. The number of stages can be different in the ESD overvoltage circuit compared to the ESD undervoltage circuit.

The number of stacked diodes and stacked pass devices can be tuned separately for the primary and secondary stages. For example, the first stage has two diodes 513 and the second stage has one diode 601. In another example, the first stage has three pass devices Tc, Td and Te and the second stage has one pass device T54. The gate control signal can be shared between the first and second stages (e.g., at nodes 518 and 602.)

This variant of the ESD overvoltage circuit is optimized for a low breakdown voltage of the victim circuit. A pass device is placed in two instances (T53 and T54) with a resistor 570 (e.g., R-ballast) in between. The first and second pass devices are connected to the same timer circuit via the gate control nodes 518 and 602. This refers to an external timer circuit that provides the signal on the gate control nodes. During an ESD event, the victim circuit 580 is protected by an additional voltage drop over the resistor 570 (e.g., a 5-50 Ohm resistor).

In this implementation, the second stage 510a comprises a non-stacked device T54. The number of stacked pass devices in the first and second stages can vary in alternative implementations. Additionally, the second stage 510a comprises one series diode 601. The number of diodes in the first and second stages can vary in alternative implementations.

In this implementation, the stages 510 and 510a are codesigned together with reverse diode stages to fulfill an overvoltage requirement in a fail-safe pad.

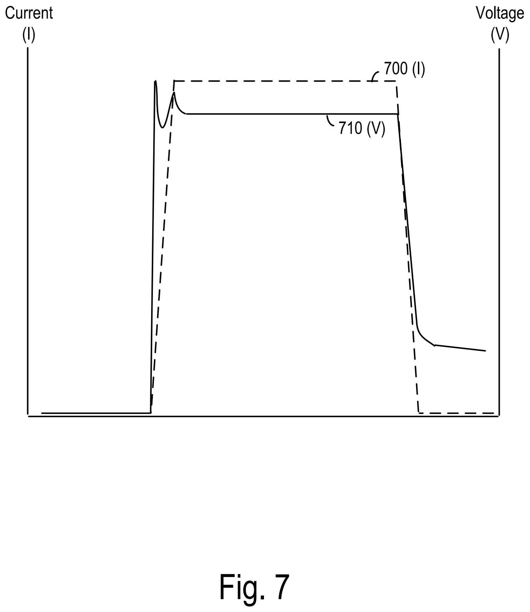

FIG. 7 depicts plots of current and voltage in the circuits of FIGs. 5 and 6, indicating how a pad voltage is clamped when an overvoltage ESD event occurs, in accordance with various embodiments. The plot 700 depicts a CDM current stress which is applied to the pad, and the plot 710 depicts a corresponding voltage of the pad. As can be seen, the voltage is clamped and remains at a fixed level while the current is applied. This demonstrates that the victim circuit is protected.

In an example, a positive rectangular current pulse having a magnitude of 6 A CDM stress, a rise-time and fall time of 100ps, and duration of 1ns was applied to the pad. The ESD clamping voltage is about 3.1 V, which is sufficient for protection of the Tx/Rx drivers of the victim circuit.

The transient current pulse is forced to pad versus Vss. The disable node 518 (FIG. 5) remains floating in this simulation.

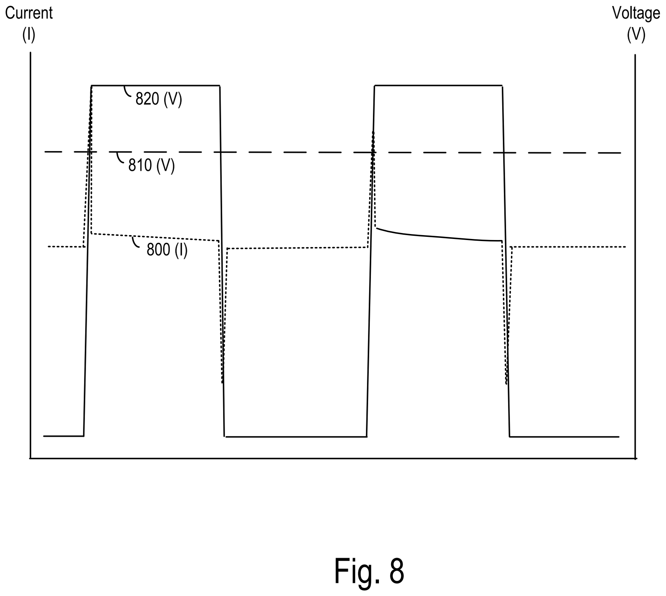

FIG. 8 depicts plots of current and voltage in the circuits of FIGs. 5 and 6, indicating how the ESD circuit is not triggered when a pad voltage toggles, in accordance with various embodiments. The toggling may be part of a digital signal in I/O communications of the Rx/Tx, for instance. A plot 800 depicts an I/O pad current, a plot 810 depicts a voltage of the Vsd disable node 518 of FIG. 6, and a plot 820 depicts an I/O pad voltage.

The functional simulation is for an ESD overvoltage circuit coupled to a fail-safe pad. A digital signal with a slew rate of about 5 ns toggles between 0 V and 1.2 V. The slew rate of the toggling signal is in range of an ESD event. It, however, does not trigger the ESD overvoltage circuit since the Vsd pin (node 518) is attached to an always-on supply and is powered, e.g., at least 25 μs before toggling. In this example, the always-on supply (Vsd) is a core supply ramped to 750 mV.

In sum, the ESD overvoltage circuit provides a number of features. For example, ESD protection for a fail-safe pad is realized with bulk-less devices. The ESD overvoltage circuit can include a diode at the pad stacked with an n-channel or p-channel pass device. The pass device can be controlled by control logic such as a timer to detect an ESD event in an unpowered state and to enforce a high-Z (high impedance) condition in operation, when an ESD event is detected. The high-Z state of the pass device in operation can be controlled by a disable signal from an always-on supply or by control logic. The always-on supply should be enabled before the toggling of the fail-safe pad. Additionally, the number of stacked pass devices, stacked diodes, and stages of the ESD overvoltage circuit can be changed as needed and is not limited to the examples depicted herein.

FIG. 9 depicts an example circuit 900 corresponding to the circuit 500 of FIG. 5 and including details of the ESD circuit 530 for handling an undervoltage ESD event, in accordance with various embodiments. The circuit 510, discussed previously, is for handling an overvoltage and the circuit 530 is for handling an undervoltage. The circuit 530 includes one or more diodes 913 in a stacked/series configuration, a capacitor C90 and a resistor R90 in a series path 925 between the rails 201 and 202. The voltage at a node 914 which is between C90 and R90, is coupled to the input of a first inverter 910. The diodes 913 and the inverter 910 are in a series path 927. The output of the first inverter 910, at a node 915, is coupled to the control gates of a second inverter 920. The first inverter comprises an n-type transistor 910a coupled to the node 917 and a p-type transistor 910b coupled to the rail 202. The second inverter comprises an n-type transistor 920a coupled to the node 917 and a p-type transistor 920b coupled to the rail 202.

The diodes 913 and the inverter 920 are in a series path 928. The two inverters 910 and 920 are in parallel. An output of the second inverter, at a node 921, is coupled to the gate of an n-type transistor T80. When T80 is conductive, the node 917 is coupled to the ground rail. The node 917 is also coupled to a node 916 which is between the diodes 913 and C90.

The node 914 is coupled to the ground rail via R90 and via an n-type MOSFET T100. A gate of T100 is coupled to a node 918 via a resistor R91. A node 919 which is between R91 and T100 is coupled to the node 916 via a capacitor C91. A Vsd disable node 918 is coupled to R91 and to an always-on supply voltage.

The arrow 926 indicates that the transistor T80 may alternately comprises multiple transistors in series such as Tf, Tg and Th. This, along with stacking of the diodes 913, reduces current leakage.

During an undervoltage event, also referred to as a positive CDM zap, a current flows in a path 911 from the rail 202, through T80 and the diodes 913 to the I/O rail 201.

The ESD circuit 530 is used for shunting ESD current for an undervoltage tolerant pad and can be realized with newer-technology transistors such as bulk-less or GAA transistors.

The specification of the ESD circuit 510 can be similar to the corresponding ESD circuit 220 which is realized with an older-technology planar process. As an example, the leakage of the ESD circuit 530 can be specified as being, e.g., <100uA at maximal signal swing. The ESD clamping voltage should be kept below the breakdown voltage of the victim circuit, e.g., <3-5 V.

The high current path in the ESD circuit 530 can comprise at least one diode stacked with an n-channel or p-channel pass device, e.g., T80.

The pass device is controlled by a driver, e.g., inverters 910 and 920, and a first RC timer 530t1 which operates based on R90 and C90. The timer 530t1 opens the gate of the pass device (e.g., turning on/making conductive T80) via the inverters when an undervoltage at its terminal 914 is detected.

Specifically, a high voltage at node 914, the input of the inverters, results in a high voltage at the output of the inverter and the gate of the n-type transistor T80, turning it on. Before the ESD event, during normal operations, the node 914 is coupled to the ground rail via T100 so that the output of the inverter is low and T80 is off. Since the signal toggling at the I/O rail 201 can have slew rates in the nanosecond regime (corresponding to 1-5GHz), it can potentially trigger the pass device.

Under the negative voltage, the Vss rail 202 becomes the higher potential node in the circuit (higher than the I/O rail 201). In the example implementation, the first and second inverters 910 and 920, respectively, have an upside-down configuration with the p-type transistors 910a and 910b at the bottom of the inverters, coupled to Vss, to provide the functionality of a timer block.

A shut down circuit is introduced to keep the pass device T80 off. It includes T100 as a pull-down transistor and a second timer 530t2 based on R91 and C91. The second timer should be connected to an always-on supply before the I/O starts toggling, to disable the first timer 530t1 for the pass device T80.

The construction of timers is not limited to the topology depicted.

For overvoltage protection, the ESD discharge current path for positive current at the pad can be realized as discussed, e.g., in FIGs. 5 and 6. In this case, the ESD circuit 530 remains off since the diodes 913 in series with the pass device T80, in the series path 990, are reverse biased.

FIG. 10 depicts an example circuit 1000 including details of a two-stage ESD circuit for handling a negative ESD event, in accordance with various embodiments. The circuit 1000 includes the ESD circuit 530 of FIG. 9 as a first stage of a two-stage ESD undervoltage circuit, in addition to a second stage 530a of the two-stage ESD undervoltage circuit. The second stage includes in a series path 1025, a diode 1001 and an n-type transistor T101 having a node 1002 coupled to a gate control voltage. The node 1002 can be coupled to the node 918, for example.

The second stage 530a allows an additional current to flow in a path 911a which extends from the rail 202 through T101 and the diode 1001 to the I/O rail 201. In an example implementation, the current in the second stage is less than the current in the first stage.

The number of stacked diodes and stacked pass devices can be tuned separately for the primary and secondary stages. For example, the first stage has two diodes 913 and the second stage has one diode 1001. In another example, the first stage has three pass devices Tf, Tg and Th and the second stage has one pass device T101. The gate control signal can be shared between the first and second stages (e.g., nodes 918 and 1002.)

This variant of the ESD undervoltage circuit is optimized for a low breakdown voltage of the victim circuit. A pass device is placed in two instances (T80 and T101) with a resistor 570 (e.g., R-ballast) in between. The first and second pass devices are connected to the same timer circuit via the gate control nodes 918 and 1002. This refers to an external timer circuit that provides the signal on the gate control nodes. During an ESD event, the victim circuit 580 is protected by an additional voltage drop over the resistor 570.

In this implementation, the second stage 530a comprises a non-stacked device T101. The number of stacked pass devices in the first and second stages can vary in alternative implementations. Additionally, the second stage 530a comprises one series diode 1001. The number of diodes in the first and second stages can vary in alternative implementations.

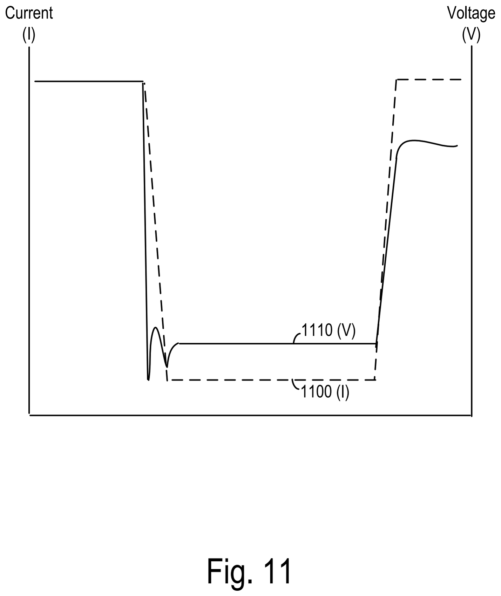

FIG. 11 depicts plots of current and voltage in the circuits of FIGs. 9 and 10, indicating how a pad voltage is clamped when a positive ESD event occurs, in accordance with various embodiments. The plot 1100 depicts a CDM current stress which is applied to the pad, and the plot 1110 depicts a corresponding voltage of the pad. As can be seen, the voltage is clamped and remains at a fixed level while the current is applied. This demonstrates that the victim circuit such as the Tx/Rx drivers, is protected.

In an example, a negative rectangular current pulse having a magnitude of -6 A CDM stress, a rise-time and fall time of 100ps and duration of 1ns was applied to the pad. The ESD clamping voltage is about -3.1 V, which is sufficient for protection of the Tx/Rx drivers.

The transient current pulse is forced to pad versus Vss. The disable node 518 (FIG. 5) remains floating in this simulation.

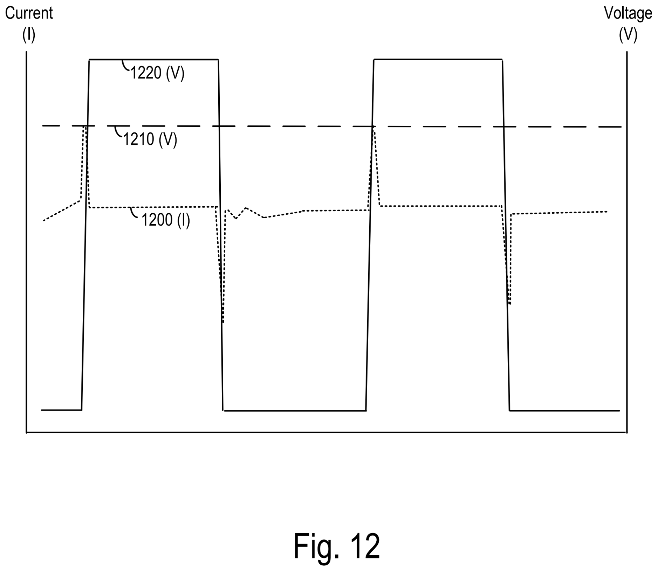

FIG. 12 depicts plots of current and voltage in the circuits of FIGs. 9 and 10, indicating how the ESD circuit is not triggered when a pad voltage toggles, in accordance with various embodiments. A plot 1200 depicts an I/O pad current, a plot 1210 depicts a voltage of the Vsd disable node 518 of FIG. 6, and a plot 1220 depicts an I/O pad voltage.

The functional simulation is for an ESD undervoltage circuit coupled to a fail-safe pad. A digital signal with a slew rate of about 5ns toggles between 0 V and -1.2 V. The slew rate of the toggling signal is in range of an ESD event. It, however, does not trigger the ESD undervoltage circuit since the Vsd pin (node 918) is attached to an always-on supply and is powered, e.g., at least 25µs before toggling. In this example, the always-on supply is a core supply ramped to 750mV.

In sum, the ESD undervoltage circuit provides a number of features. For example, ESD protection for a fail-safe pad is realized with bulk-less devices. The ESD clamping voltage is lower than for other solutions which use just stacked diodes or bipolar breakdown elements. The clamping voltage, leakage and capacitance of the ESD undervoltage circuit can be programmed by resizing and/or stacking of the pass device.

## II. ACTIVE CLIPPER DEVICE FOR ESD PROTECTION

The solution can be added as an additional stage of ESD protection for PS-PD on the driver side. That is, this is the driver protection for the solution of part I.

ESD protection for high-speed or high-frequency (HF) interfaces is constrained in terms of capacitive budget to allow for the required bandwidth. Some solutions rely on ESD diodes with a reduced width to comply with such specifications, yielding increased overshoot and clamping voltages that cause a Charged Device Model (CDM) test failure. Voltage overshoots on the power supply network are also detrimental to the clamping capabilities of Complementary Metal-Oxide-Semiconductor (CMOS) devices at high frequencies, requiring additional area overhead for CDM compliance.

To improve ESD robustness, ballasting of ESD victim circuits with resistors or decoupling with capacitors can be used. For most common configurations of drivers with a ballast in a planar process, primary diode overshoots at the Rx or Tx victim circuit can be mitigated by a parasitic body diode of a driver that clips the current to supply or ground.

However, in newer-technology transistors such as bulk-less or GAA transistors, the body diode might be not available, as mentioned, due to the architecture of ribbons that are processed on insulating substrate, for instance.

The solution herein provides designs to enable a local current shunt (clipper) for victim protection in Rx or Tx circuits, for example.

These and other features will be further apparent in view of the following discussion.

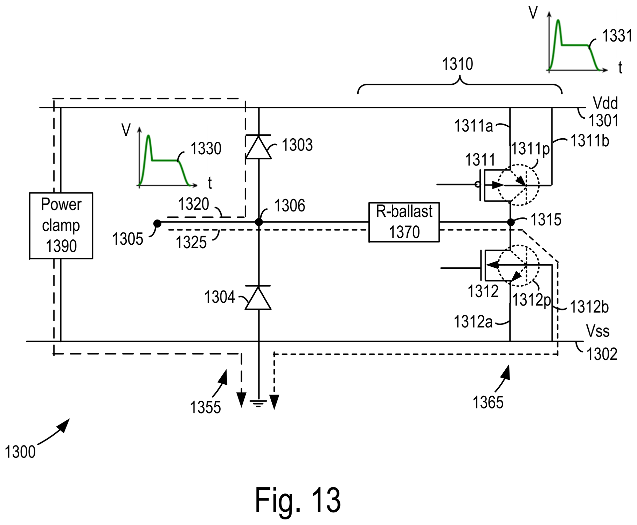

FIG. 13 depicts an example ESD circuit 1300 based on diode protection, in accordance with various embodiments. This circuit provides an example for high-frequency ESD protection of a Tx circuit 1310, which includes a p-type transistor 1311 and an n-type transistor 1312, such as MOSFETs, in a series path 1365 between a power supply rail 1301 at Vdd and a ground rail 1302 at Vss. The Tx circuit 1310 can be a ballasted driver leg. A node 1315 between the transistors is coupled to a resistor 1370 (R-ballast) which in turn is coupled to a node 1306 in a series path 1355 which includes diodes 1303 and 1304 connected in series between the rails. A pad 1305 is a node through which the Tx can transmit data. The circuit 1300 also includes a power clamp 1390 between the rails.

The diode 1303 has its anode coupled to the node 1306 and its cathode coupled to the power supply rail 1301. The diode 1304 has its anode coupled to the power supply rail 1301 and its cathode coupled to the node 1306.

During an ESD event at the pad 1305, a current flows in a path 1320 through the diode 1303 to the rail 1301, through the power clamp 1390, to the rail 1302 and to ground. A plot 1330 depicts voltage versus time at the pad 1305, and a plot 1331 depicts voltage versus time at the power supply rail 1301. The voltage at the power supply rail might exceed the voltage at the pad by 2-3 V, for example.

The transistor 1311 is a closed/off device which is coupled to the rail 1301. The transistor 1311 includes parasitic pnp device 1311p with Vc-Ve<Vbd of about 3-4 V. Vc is the collector voltage, Ve is the emitter voltage and Vbd in the breakdown voltage of the base-collector junction. In a MOSFET, parasitic pnp and npn devices refer to unintended, small bipolar transistors that are formed inadvertently within the MOSFET's structure due to the underlying semiconductor doping. The parasitic pnp device 1311p is coupled to the rail 1301 via a path 1311b, and a source of the transistor 1311 is coupled to the rail 1301 via a path 1311a.

The transistor 1312 is an open/on device which is coupled to the rail 1302 during an ESD event. The transistor 1312 includes parasitic npn device 1312p which is coupled to the rail 1302 via a path 1312b, and a source of the transistor 1312 is coupled to the rail 1302 via a path 1312a.

The transistor 1311 is off (closed/non-conductive) during an ESD event. The parasitic pnp of the transistor 1311 is closed (non-conductive), and the parasitic npn of the transistor 1312 is open (conductive), providing the current path 1325.

Also during the ESD event at the pad 1305, a residual current flows in a path 1325 through the resistor (R-ballast) 1370 and the transistor 1312, to the rail 1302 and to ground. There is a residual voltage drop in this transistor.

The current flow under a worst-case negative CDM stress is depicted by the path 1320. A positive current is forced into the pad and is discharged towards Vss.

Typical CDM stresses are characterized, e.g., by high current magnitudes of <6 Amps within very fast transients (in the range of 20-300 ps), thus leading to large di/dt values that can cause severe voltage overshoots due to wiring inductance. Moreover, the ESD diode itself introduces voltage overshoots at high-current switching due to the forward recovery of the junction. Also, the power clamp is not able to switch the CDM current instantaneously, which can lead to additional overshoots during turn-on. The voltage overshoots appear at the supply and elevates its voltage under CDM stress. See the plot 1331. Such overshoots can limit the clamping efficiency of the ESD network, since an elevated potential at the supply prevents opening of the current paths, e.g., in the driver or driver's body diode after R-ballast.

Each ballasted driver stage with an n-channel/p-channel driver contains several parasitic current paths that increase current through the ballast resistor and assist protection of the driver by providing a voltage drop at the resistor (R-ballast) 1370. For example, a current path can be provided by a MOS channel of a driver, which is not fully utilized, since the gate voltages of the driver are not defined under ESD. Additionally, a current path can be provided via a parasitic bipolar npn in an n-channel device and pnp in a p-channel device. The npn might drive the current due to a sufficient voltage difference to Vss. Whereas, in some solutions the pnp might not be triggered due to the overshoots at the supply. The voltage difference between the emitter and collector of a BJT can be too small when the supply is oscillating.

Another current path can be provided by a body diode of an n-channel or p-channel device to Vss and Vdd. It can be utilized a in bulk process, but is not available in devices using newer-technology transistors.

The above discussion of active ESD parasitic paths in a ballasted driver indicates that it would be advantageous to provide solutions to assist the current flow at Rballast with additional measures. Moreover, the solutions should be compatible with newer-technology transistors to provide ESD protection on par with technologies of bulk processes.

The ballasting element can be realized, e.g., with a capacitor and/or resistor which has high impedance (high-Z) during ESD stress. In a high-speed circuit, the impedance is frequently reduced due to the HF performance of the Rx or Tx circuits. To provide sufficient voltage drop over the ballast, the current across the impedance should be increased. All possible MOS and parasitic current paths should be activated during an ESD event. Moreover, the size of the drivers should be reduced to minimize the capacitive load of the Rx or Tx circuits.

The solutions herein address the above and other issues by providing a codesign of ESD protection for ESD victim circuits (e.g., Rx receiver-gate and Tx driver) using newer-technology transistors.

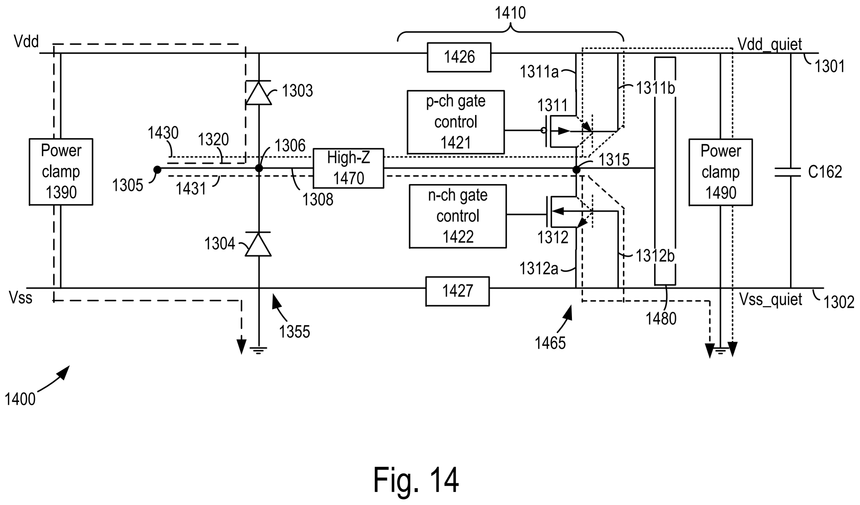

FIG. 14 depicts an example ESD circuit 1400 including a clipper circuit 1410, in accordance with various embodiments. A victim circuit 1480 is coupled between the rails 1301 and 1302 and to the node 1315. The victim circuit can comprise a Tx and/or Rx such as described previously, for example. A control gate of the p-type transistor 1311 is coupled to a p-ch (p-channel) gate control circuit 1421, and a control gate of the n-type transistor 1312 is coupled to an n-ch (n-channel) gate control circuit 1422. The transistors are in a series path 1465 between the two rails. The rails 1301 and 1302 also include respective resistors 1426 and 1427 such as 1 kOhm resistors. An additional power clamp 1490 and a capacitor C162 are coupled between the rails. A high-Z device 1470 or ballast is coupled between the nodes 1306 and 1315, in series with a path 1308 between the nodes 1306 and 1315.

An exemplary two-stage ESD circuit is provided. The first stage includes the low-capacitance diodes 1303 and 1304 as a clipper circuit and the second stage includes an additional clipper circuit 1410. Generally, a clipper circuit limits the amplitude of an input signal by clipping off any portion of the signal that exceeds a predetermined voltage level.

The second stage also includes a high-Z device 1470 implemented as a resistor (e.g., 10-10k Ohms) and/or series capacitors (e.g., 0.5-1pF), to provide ballast at the Rx/Tx victim circuit. An additional n-channel/p-channel clipper circuit is introduced to shunt residual current close to the victim circuit via a bipolar and MOS channel.

The n-channel/p-channel clipper circuit 1410 includes gate control circuits 1422 and 1421 that can provide conduction of both the n-channel and p-channel transistors 1312 and 1311, respectively, under positive and/or negative ESD stress.

The supply and ground of the clipper circuit 1410 can be decoupled by resistors 1426 and 1427 from the major current path via Vdd and Vss. They maximize a voltage drop under ESD stress and help isolate the ground and/or supply of the clipper circuit.

The circuit 1400 handles both negative CDM stress (positive voltage at the Rx/Tx of the victim circuit) and positive CDM stress (negative voltage at the Rx/Tx). The current paths for positive current stress during an ESD event are indicated. The path 1320 is provided as discussed previously. Additionally, a current path 1430 is a residual current path via the p-channel transistor 1311. The current path 1430 extends from the pad 1305 (e.g., an I/O pad) through the high-z device 1470 and the transistor 1311 (on paths 1311a and 1311b) to the rail 1301, and then through the power clamp 1490 to the rail and 1302 and ground. A current path 1431 is a residual current path via the n-channel transistor 1312. The current path 1431 extends from the pad 1305 through the high-z device 1470 and the transistor 1312 (on paths 1312a and 1312b) to the rail 1302 and to ground. The high-z device 1470 provides a voltage drop.

The transistor 1311 is on, so that current flows on the path 1311a, and the transistor 1312 is on, so that current flows on the path 1312a. The parasitic pnp of the transistor 1311 is open, so that current flows on the path 1311b, and the parasitic npn of the transistor 1312 is open, so that current flows on the path 1312b.

During the ESD event, the transistors 1311 and 1312 are turned on by the respective control circuits. During normal operations, the transistors 1311 and 1312 are turned off.

The voltage on the power supply rail 1301 is Vdd at the left side of the clipper circuit 1410 and Vdd_quiet at the right side of the clipper circuit 1410. The voltage on the ground rail 1302 is Vss at the left side of the clipper circuit 1410 and Vss_quiet at the right side of the clipper circuit 1410. The quiet values denotes voltages which are not spiked by an ESD event due to the isolation provided by resistors 1426 and 1427.

The clipper circuit 1410 is in parallel with the victim circuit 1480.

For a reverse current polarity in an ESD event, the current paths remain the same. They can, however, differ in alternative implementations, where the current paths are not symmetric.

The solution provides a number of advantages. For example, the solution allows porting of a driver architecture from a bulk process to newer transistor technologies without adding overhead for area and capacitive load. The solution is compliant with a driver architecture for a high-bandwidth interface. The solution provides a reduction in area and capacitance for the primary ESD diodes. The solution also mitigates fabrication process/layout-dependent overshoots at the primary ESD diodes due to inductance of wiring and diode forward-recovery.

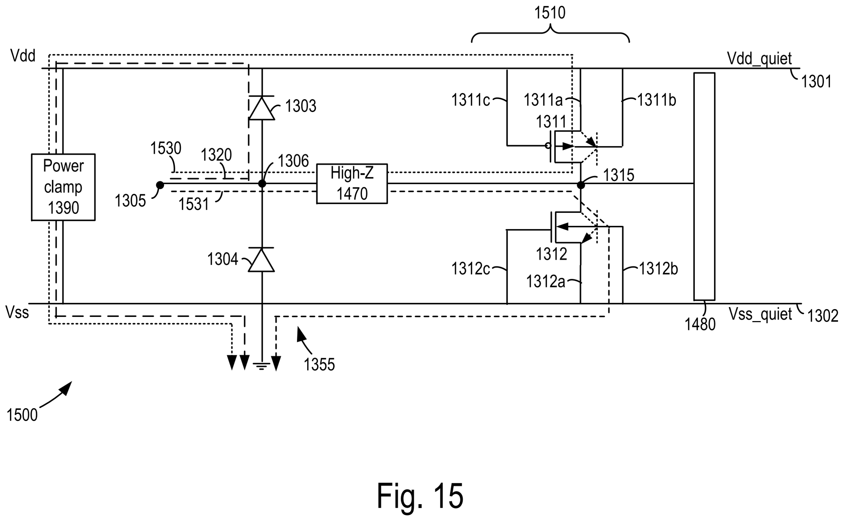

FIG. 15 depicts another example ESD circuit 1500 including a clipper circuit 1510, in accordance with various embodiments. Here, the n-channel and p-channel transistors of the clipper circuit 1510 provide a minimal functionality in terms of passing current during an ESD event. The gate control is realized as a hard-tie of the n-channel/p-channel transistors to Vss/Vdd. Specifically, the gate of the p-type transistor 1311 is coupled to the power supply rail 1301 via a path 1311c, and the gate of the n-type transistor 1312 is coupled to the ground rail 1302 via a path 1312c.

The decoupling resistors 1426 and 1427 of FIG. 14 can be reduced to a minimal value in the range of the routing resistance and therefore are not specifically shown in this example.

During an ESD event, in the p-type transistor 1311, the gate is opened due to a voltage drop between the pad and Vdd in the range of the diode threshold (diode 1303). The pnp device in the p-type transistor is closed, since the voltage difference between the emitter and collector might not be sufficient, since it is provided by the primary diode 1303 between the pad 1305 and the rail1301.

The gate of the n-type transistor is tied to Vss so that the transistor is turned off. The transistor 1312 can, however, still drive current with the parasitic action of the parasitic npn device.

In this implementation, the current through the transistors is not maximized, but still can provide a sufficient voltage via the voltage drop of the high-Z device 1470 to protect the victim circuit 1480.

During an ESD event, the current path 1320 is provided as discussed previously. Additionally, a current path 1530 is a residual current path via the p-channel transistor 1311. The current path 1530 extends from the pad 1305 through the high-z device 1470 and the transistor 1311 (on path 1311a) to the rail 1301, and then through the power clamp 1490 to the rail 1302 and ground. A current path 1531 is a residual current path via the n-channel transistor 1312. The current path 1531 extends from the pad 1305 through the high-z device 1470 and the transistor 1312 (on path 1312b) to the rail 1302 and to ground.

The transistor 1311 is on and the transistor 1312 is off. The parasitic pnp of the transistor 1311 is closed, so that current does not flow on the path 1311b, and the parasitic npn of the transistor 1312 is open, so that current flows on the path 1312b.

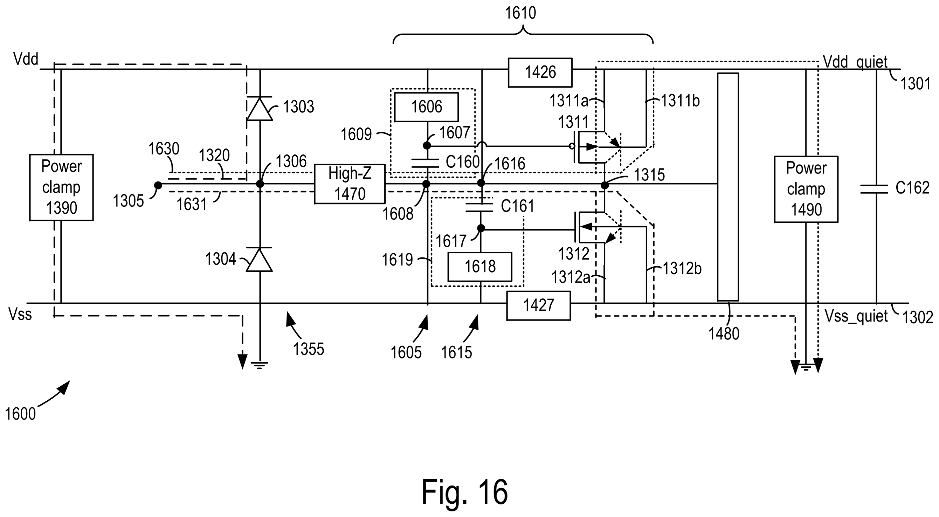

FIG. 16 depicts another example ESD circuit 1600 including a clipper circuit 1610, in accordance with various embodiments. The circuit includes a serial path 1605 coupled to the rails 1301 and 1302 and including a resistor 1606, a node 1607 coupled to a control gate of the p-type transistor 1311, a capacitor C160, and a node 1608 coupled to the high-Z device 1470. The circuit also includes a serial path 1615 coupled to the rails 1301 and 1302 and including a node 1616 coupled to the high-Z device 1470, a capacitor C161, a node 1617 coupled to a control gate of the n-type transistor 1312, and a resistor 1618. The resistors 1426 and 1427 of FIG. 14 are also included.

The resistor 1606 and C160 are part of an RC timer 1609 for the p-type transistor 1311, and the resistor 1618 and C161 are part of an RC timer for the n-type transistor 1312.

Here, the n-channel and p-channel transistors of the clipper circuit 1510 provide a maximum functionality in terms of passing current during an ESD event.

The gate control of the transistors 1311 and 1312 is realized by the RC timers 1609 and 1619, respectively. The decoupling resistors 1426 and 1427 are placed between the timers' reference voltages and clipper circuit's reference voltages to maximize coupling of overshoots in the timer and overdrive of the transistor gates.

The transistors are tied to the rails at Vdd_quiet and Vss_quiet to maximize the voltage difference of the Rx/Tx node 1315 to supply and bust the parasitic npn/pnp action.

During an ESD event, the current path 1320 is provided as discussed previously. Additionally, a current path 1630 is a residual current path via the p-channel transistor 1311. The current path 1530 extends from the pad 1305 through the high-z device 1470 and the transistor 1311 (on paths 1311a and 1311b) to the rail 1301, and then through the power clamp 1490 to the rail 1302 and ground. A current path 1631 is a residual current path via the n-channel transistor 1312. The current path 1631 extends from the pad 1305 through the high-z device 1470 and the transistor 1312 (on paths 1312a and 1312b) to the rail 1302 and to ground.

The transistor 1311 is on and the transistor 1312 is on. The parasitic pnp of the transistor 1311 is open, and the parasitic npn of the transistor 1312 is open.

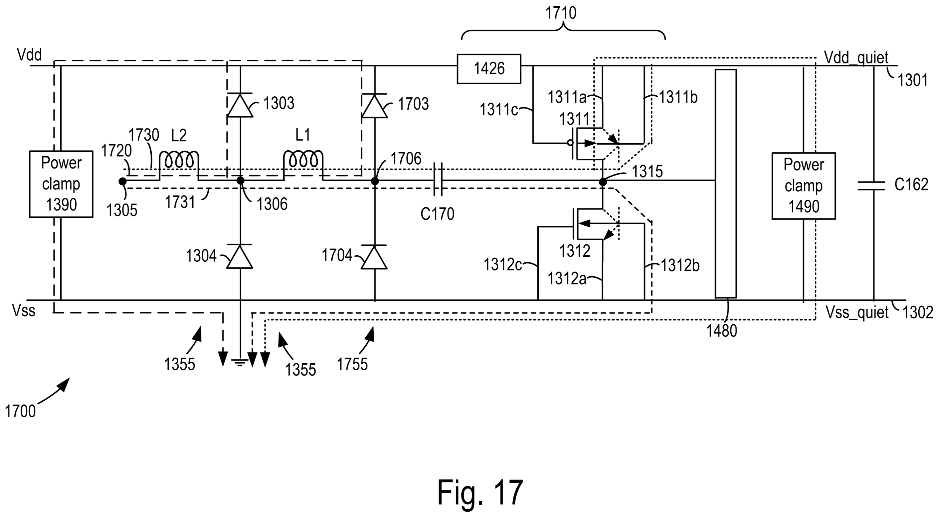

FIG. 17 depicts another example ESD circuit 1700 including a clipper circuit 1710, in accordance with various embodiments. The circuit includes an additional series path 1755 with diodes 1703 and 1704 coupled to the rails 1301 and 1302. A capacitor C170 is coupled between the node 1315 and a node 1706 in the series path 1755. A first inductor L1 is coupled between the nodes 1306 and 1706 and a second inductor L2 is coupled between the pad 1305 and the node 1306.

The inductors and codesigned diode stages are in a T-line (transmission line). The supply Vdd is decoupled by the resistor 1426 to minimize voltage overshoots at Vdd_quiet during an ESD event.

The victim circuit 1480 is a Rx in this example. Since the ESD protection is applied for the Rx circuit, C170 (e.g., 1pF) is applied as a high-Z decoupling element, and provides a voltage drop similar to the high-Z device during an ESD event.

The gate of the n-type transistor 1312 is tied to the power supply rail 1301 and Vdd_quiet by the path 1311c, and the gate of the p-type transistor 1311 is tied to the ground rail 1302 and Vss_quiet by the path 1312c.

In this configuration, the parasitic pnp device and the channel of the n-type transistor 1311 can both drive current. In contrast, under positive current stress, the parasitic npn device but not the channel of the n-type transistor 1311 can drive current.

It should be noted that for positive CDM stress, the negative current is applied to the pad 1305 or Rx bump. For a negative voltage appearing at the drain of the n-type transistor 1312, the MOS path is activated, as well as the parasitic npn device, if sufficient voltage builds up between the emitter and collector.

During an ESD event, a current path 1720 extends from the pad 1305 through L2 and the diode 1303, and through L1 and the diode 1703, to the rail 1301, then through the power clamp 1390 and to the rail 1302 and to ground. Additionally, a current path 1730 is a residual current path via the p-channel transistor. The current path 1730 extends from the pad 1305 through L2, L1 and C170, then through the transistor 1311 (on paths 1311a and 1311b) to the rail 1301, and then through the power clamp 1490 to the rail 1302 and ground. A current path 1731 is a residual current path via the n-channel transistor 1312. The current path 1731 extends from the pad 1305 through L2, L1 and C170, then through the transistor 1312 (on path 1312b) to the rail 1302 and to ground.

The transistor 1311 is on and the transistor 1312 is off. The parasitic pnp of the transistor 1311 is open, so that current flows on the path 1311b, and the parasitic npn of the transistor 1312 is open, so that current flows on the path 1312b.

In sum, the following features are provided. First is a clipper device including n-channel and/or p-channel devices for ESD protection, where the devices use newer transistor technology. The clipper device can be connected to an Rx and/or Tx bump (pad) via a high-Z element, which can include a resistor and/or capacitor. The control gate voltages of the n-channel and/or p-channel devices can be defined during an ESD event by respective gate control circuits. The major functionality of the gate control circuits is to provide a defined voltage during an ESD event. In an example implementation, the gate control circuits open the n-channel and/or p-channel devices during an ESD event.

In other aspects, reference voltages of Vdd_quiet and Vss_quiet are provided on a power supply rail and ground rail, respectively. Vdd_quiet and Vss_quiet can be decoupled from a major supply voltage Vdd or Vss by an explicit resistor or implicit resistor of metallization. The active clipper circuit can be used for Direct Pin Zap (DPZ) protection of pins exposed on a board. DPZ protection is a design consideration for safeguarding circuit pins against ESD, where a pin directly receives the ESD event, often in scenarios such as handling, connector insertion, or environmental exposure.

In other aspects, the active clipper circuit can be used for a circuit with a local-clamp network (e.g., power clamp 1490), isolated with resistance from the primary ESD discharge path. The active clipper circuit can share a timer with the power clamp timer. The timer used for the active clipper circuit can be multiplexed to a pre-driver of a driver to boost the driver operation during an ESD event.

III. DISABLE CIRCUIT FOR GATED ESD PROTECTION SUPPORTING MULTIPLE VALUES OF VSD

This solution provides a possible embodiment of the power clamp used in IP together with PS-PD and clipper. Clipper needs a power clamp in order to work properly.

RC-triggered ESD clamps are susceptible to the power-up slew-rate of the supply voltage and have their own respective Vdd power-up slew-rate threshold. Whenever the supply slew-rate is greater than this threshold, the ESD clamp triggers and consumes current in the range of Amperes. The short circuit current flows through a pass transistor which is dimensioned to shunt the ESD stress.

For a Digital Linear Voltage Regulator (DLVR), fast supply slew-rates in the range of an ESD event may be used. Hence, a dedicated control logic may be used to keep the RC-triggered ESD clamp off during ramp-up. Usually, the clamp is considered to be off, if the maximum inrush current during power-up is below a level such as 1mA, for example.

The control logic that keeps the clamp off is known as a shutdown circuit or disable circuit. It is connected to an external control signal via a separate pin, Vsd. It disables the clamp timer during the fast supply power-up. In some solutions, the shutdown circuit is designed for one specific maximum voltage of always-on supply connected to Vsd. Depending on the availability of the always-on supply in the system, a core, IO or high-voltage can be used.

Therefore, for different voltage classes at the disable pin, different power clamp circuits are designed for the same gated-supply, Vdd_esd. However, designing and maintaining several different power-clamps for one voltage class adds complexity, increases the effort and might cause layout modifications. Moreover, if the always-on supply is changed in the system, the clamp instance has to be swapped.

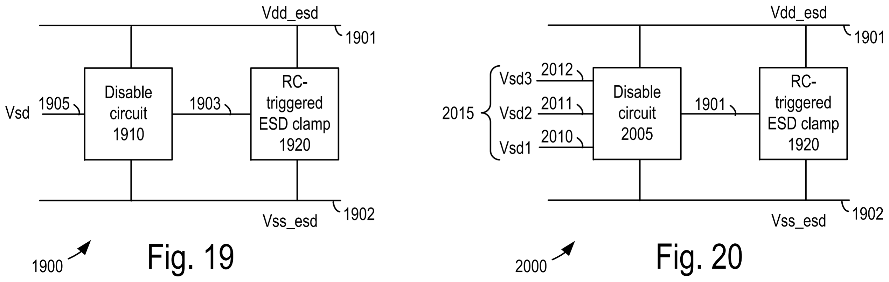

When just one voltage level at the disable-pin Vsd is supported, the always-on Vsd can be ramped several microseconds before power-up of the fast gated-supply Vdd_esd. During fast power-up, the clamp remains off. An example block-diagram of an architecture for a clamp timer and disable circuit of the gated clamp is provided in FIG. 19. The basic functionality is focused on maintaining low inrush-current during fast power-up. Various clamps might, however, differ with disable circuit specifications, e.g. power-up delay/slew-rate, Vsd voltage, leakage or area.

The solutions provided herein address the above and other issues. In one aspect, the solutions support a wide range of voltage specifications (e.g., including between about 0.5V - 1.98V, for devices using newer-technology transistors) for an always-on supply providing a disable signal at Vsd.

The solutions include a single-cell solution suitable for, but not limited to, devices using newer-technology transistors such as bulk-less or GAA transistors. The solutions provide effective control of an RC-triggered ESD clamp timer for a wide range of typically used voltage classes with several separate control pins at one disable-circuit.

In an example implementation, pins are provided for a core voltage such as Vsd=0.75V, an IO voltage such as Vsd=1.2V, and a high voltage such as Vsd=1.8V, in a single design. Each specific pin is dedicated for one specified voltage class. To activate the disable circuitry, a selected one of the Vsd pins is powered. The disable signal can be provided by an always-available external supply or a signal generated by logic preceding the power-up of the fast supply Vdd_esd.

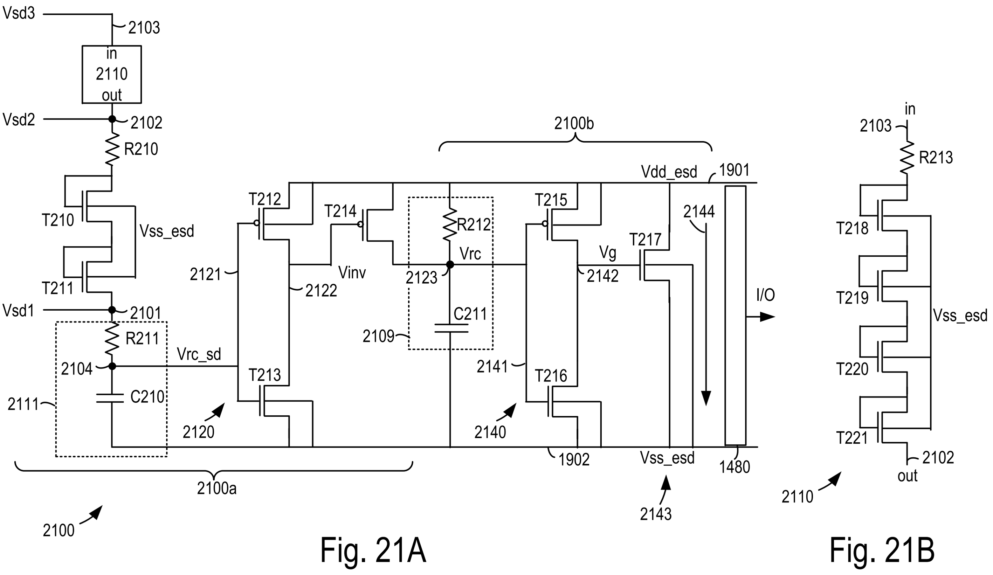

In an example implementation, the multiple disable pins are connected to one disable-circuit (FIG. 20) whose architecture is modified to provide support for multiple voltages while maintaining reliability requirements of the circuit components. The proposed solution is particularly advantageous with newer technology transistors such as the RibbonFET process, which has a single core device voltage class. Without an IO device, the reliability at high voltage can be achieved with stacked core devices and circuits such as depicted in FIG. 21A and 21B.

The solutions provide a number of advantages. For example, the simultaneous support of a wide range for Vsd is particularly advantageous for devices with newer technology transistors. The same power clamp which is designed in technology with a core device only can support a Vsd bias at the disable-pin starting from a minimal core voltage specification of, e.g., 0.5V (~0.7V nominal core voltage) up to a maximum IO voltage of, e.g., 1.98V (~1.8V nominal voltage for, e.g., Electrical Fuse (EFUSE) or DLVR.

Another advantage is that the maintenance effort is reduced if only one power-clamp cell is used to support all voltage classes. The solutions also allow for increased flexibility in planning of intellectual property (IP) circuits for power delivery. Any supply available in a partition can potentially be used as an input to Vsd in the clamp at, e.g., the DLVR output in a compute die.

Another advantage is that re-floorplanning (modifying the floorplan of a chip design) can be avoided even after modification of supply skew in a partition.

These and other features will be further apparent in view of the following discussion.

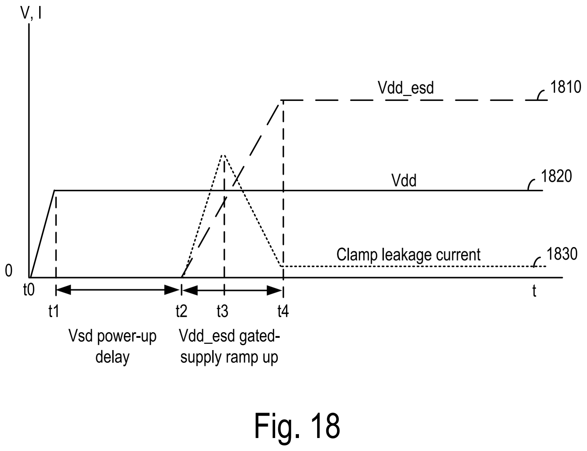

FIG. 18 depicts a power-up sequence of a power clamp with a disable circuit supplied by an always-on signal Vsd for a gated power supply Vdd_esd, in accordance with various embodiments. The plots depict voltage and current versus time. A plot 1810 depicts a supply voltage Vdd_esd which is at 0 V from t0-t2, then ramps up to its full level at t2-t4 and remains at that level after t4. Vdd_esd can be generated by a DLVR, for example. A plot 1820 depicts a supply voltage Vsd which can be one of multiple possible levels, e.g., Vsd1=0.7 V, Vsd2=1.2 V or Vsd3=1.8 V, +/- a tolerance. These voltage classes are suitable for a compute tile processed in a RibbonFET process, for instance.

Vdd_esd>Vsd in this example. Vsd ramps up to its full level at t0-t1 and remains at that level after t1. A plot 1830 depicts a clamp leakage current, denoting a leakage current from a power supply rail at Vdd_esd to a ground rail at Vss_esd. The leakage current is at 0 A from t0-t2, ramps up to a peak level from t2-t3 due to the ramp up of Vdd_esd, then ramps down from t3-t4 and remain at 0 A after t4. The time period t1-t2 denotes the Vsd power-up delay and the time period t2-t4 denotes the Vdd_esd gated supply ramp up time.

FIG. 19 depicts a block diagram 1900 of a power clamp 1920 with a disable circuit 1910 activated by a single value of Vsd, in accordance with various embodiments. The disable circuit and the power clamp (an RC-triggered ESD clamp) are disposed between a power supply rail 1901 at Vdd_esd and a ground rail 1902 at Vss_esd. The disable circuit has an output path 1903 coupled to the power clamp, and an input path 1905 to receive a single value of Vsd.

FIG. 20 depicts a block diagram 2000 of the power clamp 1920 with a disable circuit 2005 activated by multiple values of Vsd, in accordance with various embodiments. The disable circuit has a set of input paths 2015 including a first input path 2010 to receive Vsd1, a second input path 2011 to receive Vsd2, and a third input path 2012 to receive Vsd3, where Vsd3>Vsd2>Vsd1, for example.

FIG. 21A depicts a disable circuit 2100 for a gated ESD power clamp with three disable pins, in accordance with various embodiments. The disable circuit includes a shutdown/disable circuit 2100a and an RC-triggered ESD clamp 2100b. In the shutdown/disable circuit 2100a, a first pin 2101 (a first shutdown voltage node) is to receive Vsd1, a second pin 2102 (a second shutdown voltage node) is to receive Vsd2 or a third pin 2103 (a third shutdown voltage node) is to receive Vsd3. Thus, three different shutdown pins are provided for three different voltage classes supported by the disable circuit. Only one of the pins will be powered by a Vsd voltage while the voltages of the other pins are floating. If the lowest specified Vsd voltage (Vsd1) is used, then all pins can be shorted without impairing reliability.

A resistor R210 and series-connected n-type transistors T210 and T211 are coupled between the first and second pins. T210 and T211 are provided in a source-follower configuration. For an nMOSFET in a source-follower configuration, the output voltage is at the source side of the nMOSFET. The nMOSFET is operated as a linear amplifier such that the output voltage is approximately equal to the gate voltage minus the transistor's threshold voltage, Vth.

A resistor R211, node 2104 and capacitor C210 are coupled between the first pin 2101 and the ground rail 1902. R211 and C210 are part of an RC timer 2111.

A voltage-drop circuit 2110 (FIG. 21B) is coupled between the second and third pins. When Vsd3 is supplied, the voltage-drop circuit 2110 outputs Vsd2<Vsd3. When Vsd2 is supplied, the circuit 2110 is not used. Instead, T210 and T211 output VSd1<Vsd2 at the node 2101. When Vsd1 is supplied at the node 2101, the circuit 2110, T210 and T211 are not used. Accordingly, the voltage at the node 2101 is the same regardless of whether Vsd1, Vsd2 or Vsd3 is supplied. The remainder of the shutdown/disable circuit 2100a, and the RC-triggered ESD clamp 2100b, can therefore operate in the same way, e.g., with Vsd1 as an input voltage, regardless of whether Vsd1, Vsd2 or Vsd3 is supplied.

A first inverter 2120 coupled between the rails includes transistors T212 and T213 having their gates coupled together by a path 2121, which is also coupled to the node 2104 to receive a voltage Vrc_sd. An output node 2122 of the first inverter 2120 is coupled to the gate of a p-type transistor T214 to provide Vinv. T214 has a source coupled to the rail 1901 and a drain coupled to a node 2123. This node is between a resistor R212 and a capacitor C211 in an RC timer 2109. The node 2123 at Vrc is also coupled via a node 2141 to the control gates of transistors T215 and T216 of a second inverter 2140. An output node 2142 of the second inverter 2140 at Vg is coupled to the control gate of an n-type transistor T217 in a path 2143. When T217 is turned on, an ESD discharge current 2144 can flow to protect the victim circuit 1480. The victim circuit may communicate with an IO pad, not shown.

The RC-triggered ESD clamp can be modified or replaced by other variants with stacked devices, more inverter stages or additional latching circuitry, timers, and pass device realized from n-channel or p-channel stacks.

When the shutdown signal of Vsd1 is present, the Vrc_sd node charges up due to the low-pass filter formed by R211 and C210. Usually, the time-constant R211*C210 is kept outside of the ESD window, which can be in range 0.1-5us to prevent the shutdown/disable circuit from interfering with the operation of the power-clamp during an ESD event. After Vrc power-up and a delay time R211*C210, Vrc_sd becomes greater than the switching threshold voltage of the inverter 2120, and the Vinv node is pulled to ground. The clamp is in the proper state for fast power-up of Vdd_esd.

Since the proper setting of all potentials in the clamp can take a threshold time such as >25us, the power-up of Vdd_esd should be delayed until the potential at Vrc_sd is at the required voltage.

Whenever Vdd_esd is powered with a fast rise-time of, e.g., 40ns, T214 turns on. It couples the Vrc node to Vdd_esd and, thus, turns off T215 as well as turning on T216 which keeps Vg at 0 V. It prevents the big pass device T217 from turning on during these fast rise-time events. Only a residual inrush-current can be observed at power-up due to charging of the nodes and subthreshold operation of the logic as well as the pass device T217. That residual current can be specified as, e.g., <1mA (FIG. 18).

If Vsd2 is attached to an always-on supply of, e.g., a 1.2V voltage class, R210, T210 and T211 cause a sufficient voltage drop such that the maximum voltage at the Vrc_sd node is less than the breakdown voltage of the drain-to-gate-oxide of T213. Here, the time constant of the low-pass filter is defined by

$$C210*(R211+R210+\frac{1}{gm_{M11}}+\frac{1}{gm_{M12}})$$ where $g_m$ is the transconductance of the transistor T213. Since R211*C210 was already kept outside of the ESD window, the additional resistors formed by R210 and

$$\frac{1}{gm_{M11}}+\frac{1}{gm_{M12}}$$ improve the isolation of the Vrc node and further reduce the chance of an unintentional interaction of the disable-circuit with the power-clamp trigger circuitry. Otherwise, the functionality of the circuit in operation and under ESD is same as for the case of a shut-down signal attached to Vsd1.

FIG. 21B depicts an example implementation of the voltage-drop circuit 2110 of FIG. 21A, in accordance with various embodiments. The block receives Vsd3 as an input and provides Vsd2 as an output. The block includes, in series, n-type transistors T218, T219, T220 and T221. Each transistor provides a voltage drop so that the output voltage is lower than the input voltage.

When the shutdown signal is present at Vsd3, R213, T218, T219, T220, T221, R210, T210 and T211 cause a sufficient voltage drop such that the maximum voltage at the Vrc_sd node is smaller than the drain-to-gate-oxide breakdown voltage of T213. Here, the time-constant of the low-pass filter is based on the term:

$$(\frac{1}{gm_{M7}}+\frac{1}{gm_{M8}}+\frac{1}{gm_{M9}}+\frac{1}{gm_{M10}}+\frac{1}{gm_{M11}}+\frac{1}{gm_{M12}})$$ where $g_m$, is the transconductance of the transistor T213. The performance of the circuit during normal operations and during an ESD event is otherwise similar to the case when Vsd1 is used.

The number of transistors required to cause sufficient voltage drops in the path from the shutdown pin to the Vrc_sd node 2104 can be further increased or decreased depending on the specification for the timer R211*C210 and the required voltage drop to ensure the reliability of the transistors. The additional stacked n-channel and/or p-channel devices and/or resistor (R210) add to the R211 series resistance. If large enough, it increases the delay time for the ramp of the Vrc_sd node 2104.

In the example implementation of FIGs. 21A and 21B, the resistors on the Vsd pins have been designed using n-channel transistors but can also be realized using resistors and/or p-channel transistors.

The design of the RC-triggered ESD clamp can differ in other possible implementations. The functionality of the disable circuit is, however, maintained as long as the Vg potential is effectively pulled to ground during the power-up of Vdd_esd. To achieve this, extra inverter stages or pull-up/pull-down circuits can be used. In one possible implementation, the control technique using T217 may require taping of possibly high-ohmic nodes in the clamp. That technique is optimized for inrush current reduction during a fast power-up. However, the solutions herein are not limited to circuits which are optimized for inrush current reduction.

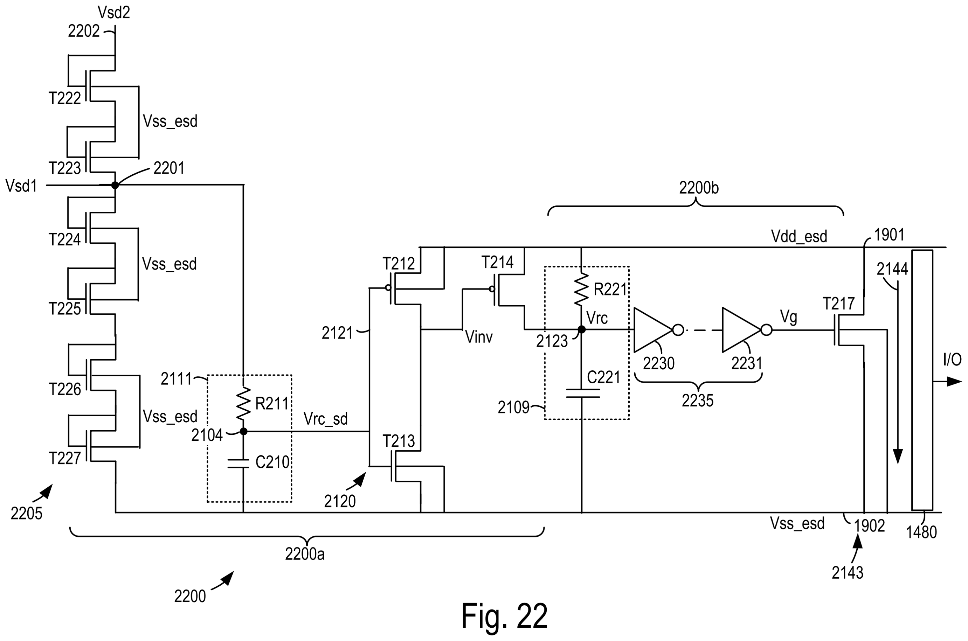

FIG. 22 depicts a disable circuit 2200 for a gated ESD power clamp with two disable pins, in accordance with various embodiments. The disable circuit includes a shutdown/disable circuit 2200a and an RC-triggered ESD clamp 2200b. The shutdown/disable circuit 2200a includes the RC timer 2111, inverter 2120 and T214 of FIG. 21A. Additionally, a ladder 2205 of n-type transistors T222-T227 is provided in a source-follower configuration. When Vsd2 is input at a node 2202, the transistors T222 and T223 drop the voltage to Vsd1 at the node 2201. Note that Vsd1 and Vsd2 can be different than in FIG. 21A.

The transistors T224, T225, T226 and T227 couple the node 2201 to the ground rail 1902. Node 2201 is also coupled as an input to the RC timer 2111.

Vrc is received at the input of a series of inverters 2235 which includes inverters 2230, ..., 2231, e.g., an odd number of inverters, to provide Vg to T217.

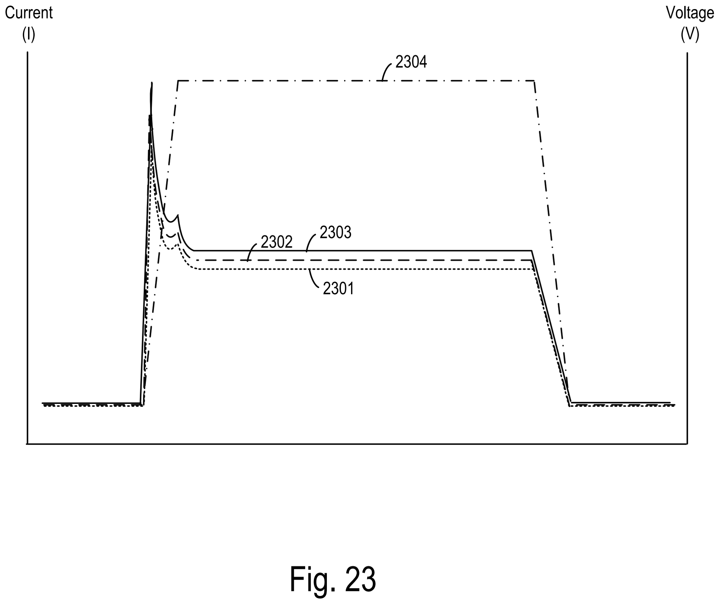

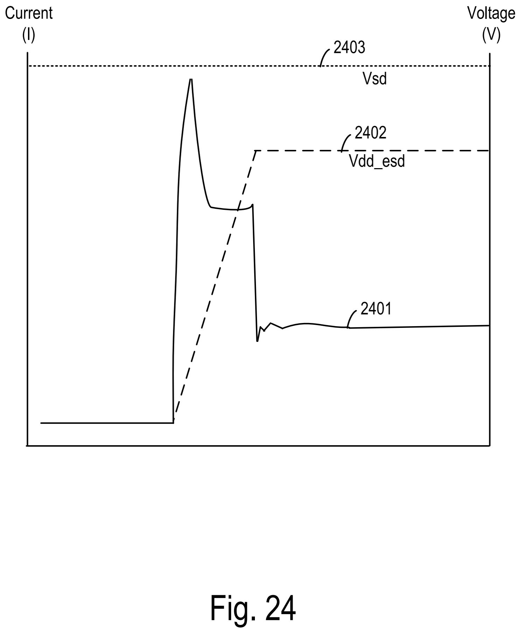

The ESD performance of the clamp is indicated in FIG. 23 and the power-up inrush current is indicated in FIG. 24.

FIG. 23 depicts plots of voltage and current versus time in a charge device model (CDM) discharge simulation of the power clamp of FIG. 21A, in accordance with various embodiments. Plots 2301, 2302 and 2303 depict the clamping voltage for progressively higher values of Vdd_esd. A plot 2304 depicts a corresponding current, which is the same for each Vsd value. The clamping voltage is maintained below a voltage which would cause damage to a victim circuit.

FIG. 24 depicts plots of voltage and current versus time during an inrush current in the power clamp of FIG. 21A, in accordance with various embodiments. A plot 2401 depicts inrush current, a plot 2402 depicts Vdd_esd, and a plot 2403 depicts Vsd. The SD_pin (Vsd) was powered up to 1.32V 25μs before power up of the Vdd_pin (Vdd_esd). Vdd_esd was ramped over 10ns from 0 V to Vdd_max, e.g., 1.05V, which is a worst case condition in the technology.

In sum, the following features are provided. First is a disable circuit with at least two separate disable pins Vsd. The disable circuit can be used to control trigger circuitry of a power-clamp. At least one of the Vsd pins can support a voltage which is higher than the voltage device class in the fabrication process. The separate disable pins Vsd can be connected via a resistor and/or a ladder of n-channel and/or p-channel transistor latches.

Additionally, at least one of the disable pins Vsd can be connected to a voltage or disable signal which is available in the system at least a minimum time, e.g., >25us, before power-up of the fast power supply Vdd_esd. If one of the Vsd pins in the disable circuit is powered, Vdd_esd can ramp with a power-up slew rate comparable to the rates of ESD events, e.g., >10ns.

If one of the Vsd pins in the disable circuit is powered, the Vdd_esd supply can be ramped with an inrush current, e.g., <1mA, without triggering the power clamp.

The disable pins can be connected via a resistor and/or n-channel and/or p-channel transistors to a low pass filter R2*C2. The low-pass filter can disable the Vg of a transistor M1 after a delay comparable to ESD discharge events in range of, e.g., 0.1-5μs.

Any RC-triggered ESD clamp circuit can be controlled by the disable circuits provided herein if the Vrc node is attached to gate of a pass device M1 or circuitry that can turn-off the pass device M1.

In example implementations, the disable circuit has two or three separate Vsd pins, although any number of Vsd pins can be provided.

IV. ON-DIE ESD DETECTION DURING DIE-TO-DIE ASSEMBLY

In case of isolated power islands used in on-die D2D, CDM detection circuit can be added to the concept. In the isolated power island concept, there are bumps shorted on the package but unprotected on die. These bumps require monitoring for CDM during assembly.

Electro-Static Discharges (ESD) can occur during die stacking in 2.5D and 3D ICs, especially during die pick-up, transfer and bonding operations. A 2.5D chip design is an advanced packaging technique that combines multiple semiconductor chips into a single package, side-by-side on a silicon interposer. In a 3D structure, chips are integrated by die stacking. The dies used for 3D integration are interconnected in a package via special die-to-die (D2D) IOs. The ESD protection devices used to prevent ESD-related damage in D2D IOs can be similar to the case of an IO pad connected to an IC ball.

The D2D IOs can be designed for a specific industry target level Charged Device Model (CDM) current. However, controlling the actual CDM discharge occurring during die-to-die bonding is not possible, as it depends on several factors that lead to a statistical distribution of the ESD current. The ESD discharge current on D2D IOs during assembly is also not accessible to measurement systems.

As a result of ESD discharge during assembly, the post-assembly yield can be affected. Some D2D IOs, however, can be only degraded as result of an ESD event and fail later after deployment. Thus, an insight into such ESD events causing only degradation but not yet full damage in assembly is useful in improving product reliability.

Some solutions for detection of CDM events in 2.5/3D assembly include yield analysis after bonding. The testing routines might have a built in scan of D2D IO functionality and flag D2D IO interfaces that were damaged. However, these solutions do not include on-die monitoring elements for ESD-specific discharges occurring during D2D bonding.

The solutions provided herein address the above and other issues.

In an example implementation, the solutions include an on-die monitoring circuit to allow for the evaluation of CDM currents during the D2D bonding after the process step is completed. The circuit can be used for quantitative CDM detection during a D2D bonding process. In an example implementation, the CDM detection circuit includes a fuse, Rfuse, and a switch with an RC timer/low-pass filter. The switch and high-pass filter can be used to detect fast slew-rates on the supply and open a low-ohmic path through Rfuse. Rfuse can be melted as a result of excessive CDM current flow. After power-up of the chip, the voltage at the Vread node changes if Rfuse was melted by CDM during assembly. The information on CDM discharge can be thus obtained by reading the voltage of the node. If Rfuse is blown, e.g., ruptured, there is an open circuit so that Vread will not be equal to Vdd, but will be lower than Vdd.

A capacitor can be used to reduce the additional direct current (DC) leakage current flowing through the fuse branch when Vdd is powered up. Its value influences the current pulse duration through the fuse and should be chosen according to the fuse specifications.

Moreover, the CDM detection circuit can be placed in parallel to a power clamp, e.g., once per power domain. In an example implementation, many, e.g., several hundred, instances of D2D IOs can be connected in one power domain. If CDM discharge occurs at one of the D2D IOs, the current is transferred via ESD diodes at the D2D pad and power bus to Rfuse to blow the fuse. Thus, a single Rfuse can indicate the presence of an ESD event for an entire power domain.

After a 3D assembly process, the voltage at an intermediate node Vread can be measured by an on-die or off-die circuit. The circuit uses the voltage to determine whether or not an ESD event has occurred. If Rfuse is blown, the voltage drifts towards ground.

In another aspect, the CDM detection circuit can be dedicated for detection of a worst-case negative CDM discharge path via the power supply. However, it can be reconfigured for detection of a positive CDM discharge if used at a D2D bump dedicated for monitoring.

The solutions provide a number of advantages. For example, monitoring of CDM current, including its magnitude, during D2D assembly is made possible. There is the potential to prevent ESD-driven D2D IO performance degradation over time. Another feature is better characterization with respect to high-level IO yield analysis. Advantageously, the solutions do not impair D2D IO size or circuit functionality. The solutions can be integrated in arrays of D2D IOs, and there is a possibility of automated readout of Vread during the testing of an assembled 3D chip.

These and other features will be further apparent in view of the following discussion.

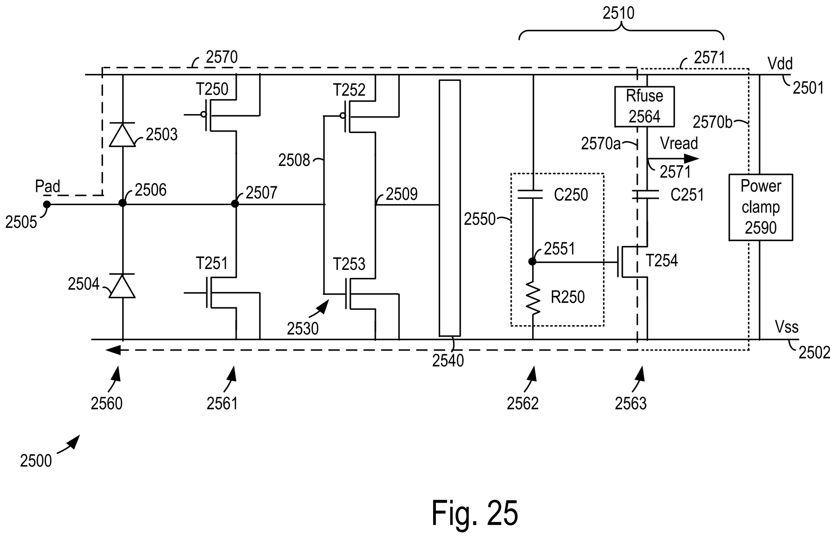

FIG. 25 depicts an example ESD circuit 2500 to detect an ESD event during die-to-die bonding, in accordance with various embodiments. The circuit includes a power supply rail 2501 and a ground rail 2502. A series path 2560 between the rails includes diodes 2503 and 2504. A pad 2505 is coupled to a node 2506 between the diodes. A series path 2561 includes a p-type transistor T250, a node 2507 coupled to the node 2506 and an n-type transistor T251. An inverter 2530 includes a p-type transistor T252, a node 2508 coupled to the node 2507 and an n-type transistor T253. A victim circuit 2540 (e.g., Rx and/or Tx) is coupled to an output 2509 of the inverter 2530. The node 2508 is the input of the inverter.

After the victim circuit, an ESD detection circuit 2510 includes series paths 2562 and 2563. The series path 2562 includes a capacitor C250 and a resistor R250 in an RC timer 2550. The series path 2563 includes a fuse 2564, Rfuse, a read node 2571, a capacitor C251 and an n-type transistor T254 having its gate coupled to the node 2551 between C250 and R250. A voltage Vread can be read out from the node 2571 to determine whether Rfuse is blown (e.g., in an open circuit or high resistance state), indicating the occurrence of an ESD event. A power clamp 2590 can also be coupled between the rails. A fuse can be blown, e.g., when a sufficiently high voltage is applied to it to cause is to overheat and melt, resulting in an open circuit.

The series path 2563 can alternatively include a resistor in place of, or in parallel with, C251. If a resistor is used in place of C251, there is no capacitor on the series path 2563, the fuse path. The capacitor can be removed if the additional leakage in DC due to the T254 off current is negligible, e.g., 10% or lower with respect to the power clamp leakage. This value depends on the target application and may vary depending on the case considered.

During an ESD event, a current path 2570 is formed. Current flows from the pad 2505 and along the power supply rail 2501. The current can flow to the ground rail in a first path 2570a in the series path 2563 and in a second path 2570b through the power clamp 2590. If the portion of the current flowing through the fuse exceeds a defined threshold, Rfuse is blown and the connection between the node 2571 and the power supply rail 2501 is removed.

In further detail, the circuit 2500 includes a D2D IO circuit, including an ESD diode stage for protection of the D2D CMOS Tx and Rx stages (victim circuit 2540), and a power clamp. Parallel to the power clamp is a detection circuit 2510 between Vss and Vdd to check for the presence of CDM currents exceeding an established limit during D2D bonding.

If no ESD event occurs, the n-type transistor T254 which is connected to Vss is not turned on during the die assembly process. In that case, no current flows through the fuse branch, and the fuse remains intact during the bonding. When the IO is powered up and Vread is measured through a readout circuit, Vdd is detected, since the fuse 2564 provides a connection to the Vss rail.

If an ESD event occurs during D2D bonding, the transient voltage on Vdd turns on the n-type transistor T254 through the RC timer 2550, and an alternating current (AC) flows in the fuse branch. The fuse can be designed to withstand up to a certain current level, corresponding to a tolerated CDM stress. If the ESD event is lower than this specification, the fuse remains intact and Vread is again equal to Vdd when measured after the bonding process. However, in the presence of a CDM current exceeding the specified limit, the fuse is blown and the connection to Vdd is removed, thus leading to Vread = 0 V after IO power up and voltage readout.

The RC timer 2550 can be designed to filter out transient voltages on the Vdd power rail 2501 which are slower than a specific cutoff value, thus avoiding a situation where T254 turns on during IO power up or in other normal operations.

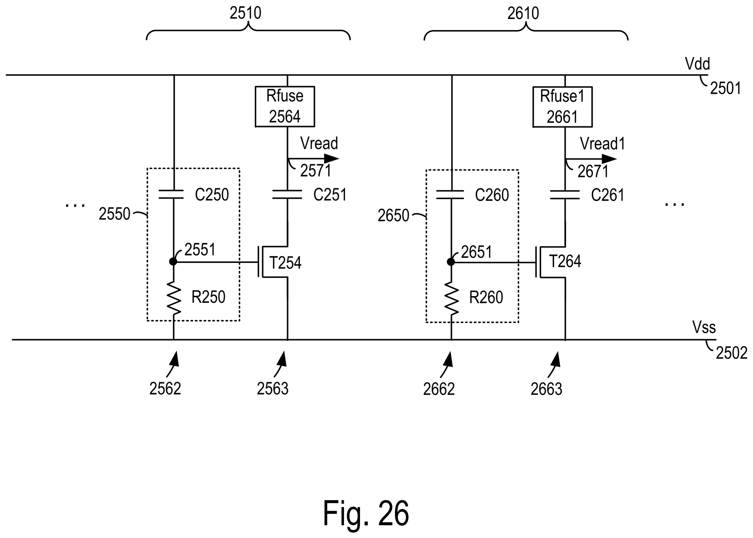

FIG. 26 depicts an example implementation of multiple detections circuits with different characteristics, including the detection circuit 2510 of FIG. 25 and an additional ESD detection circuit 2610, in accordance with various embodiments. The additional ESD detection circuit 2610 includes series paths 2662 and 2663. The series path 2662 includes a capacitor C260 and a resistor R260 in an RC timer 2650. The series path 2563 includes a fuse 2661, Rfuse1, a read node 2671, a capacitor C261 and an n-type transistor T264 having its gate coupled to the node 2651 between C260 and R260. A voltage Vread1 can be read out from the node 2671 to determine whether Rfuse1 is blown, indicating the occurrence of an ESD event.

In an example implementation, Rfuse1 requires a stronger ESD event to blow compared to Rfuse. For example, Rfuse1 may have different dimensions (a different size) and/or be made of a different material than Rfuse. Rfuse1 may thus be configured to rupture under a different ESD stress level than the Rfuse, a first fuse. In another example implementation, the RC timer 2650 has a different time constant compared to the RC timer 2550. By providing multiple detections circuits with different characteristics, different types/strengths of ESD events can be detected.

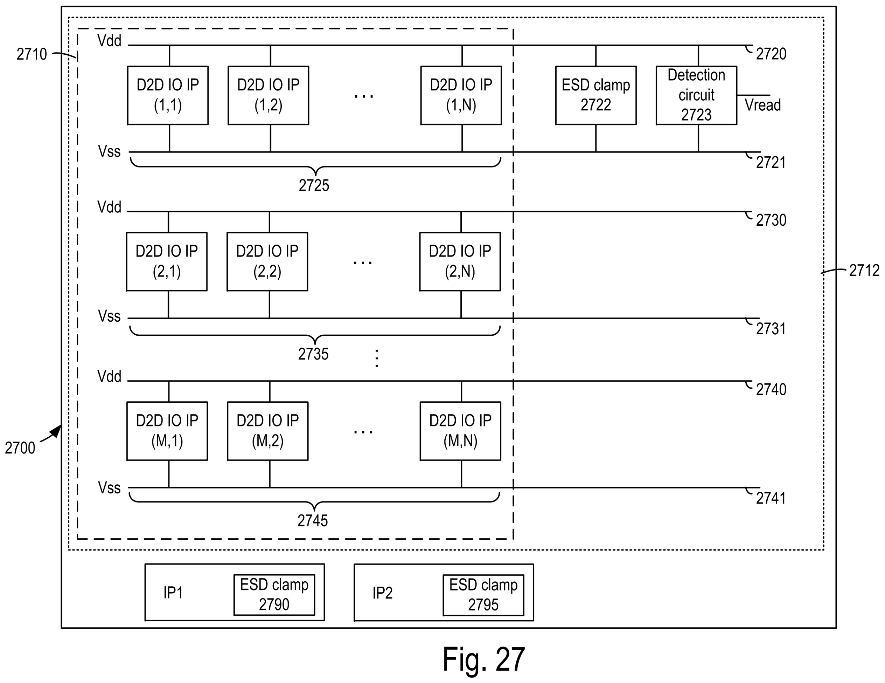

FIG. 27 depicts an example block diagram showing the placement of an ESD detection circuit in a top-down view of a die 2700, in accordance with various embodiments. The die 2700 includes an MxN array 2710 of D2D IO instances in a D2D Vdd voltage domain 2712. The array includes a first set of D2D IO IP instances 2725 (a first set of IO circuits) including D2D IO IP instances (1,1), (1,2), ..., (1,N), an ESD clamp 2722 and a detection circuit 2723, arranged between a power supply rail 2720 and a ground rail 2721. The set of input/output circuits is in parallel with a single ESD detection circuit 2723, in this example.

The array further includes a second set of D2D IO IP instances 2735 including D2D IO IP instances (2,1), (2,2), ..., (2,N), but no ESD clamp or detection circuit, arranged between a power supply rail 2730 and a ground rail 2731. The array further includes a third set of D2D IO IP instances 2745 including D2D IO IP instances (M,1), (M,2), ..., (M,N), but no ESD clamp or detection circuit, arranged between a power supply rail 2740 and a ground rail 2741. The different power supply rails can operate at the same or different voltages.

Accordingly, in this example, an ESD detection is provided for the first set of D2D IO IP instances but not for the second and third sets of D2D IO IP instances. In another example, ESD detection is provided for each set of D2D IO IP instances.

The die further includes a first IP circuit, IP1, with a respective ESD clamp 2790 and a second IP circuit, IP2, with a respective ESD clamp 2795. These are examples of circuits that have an ESD clamp to prevent damage to a victim circuit but no detection circuit to allow a diagnostic read out of an ESD event.

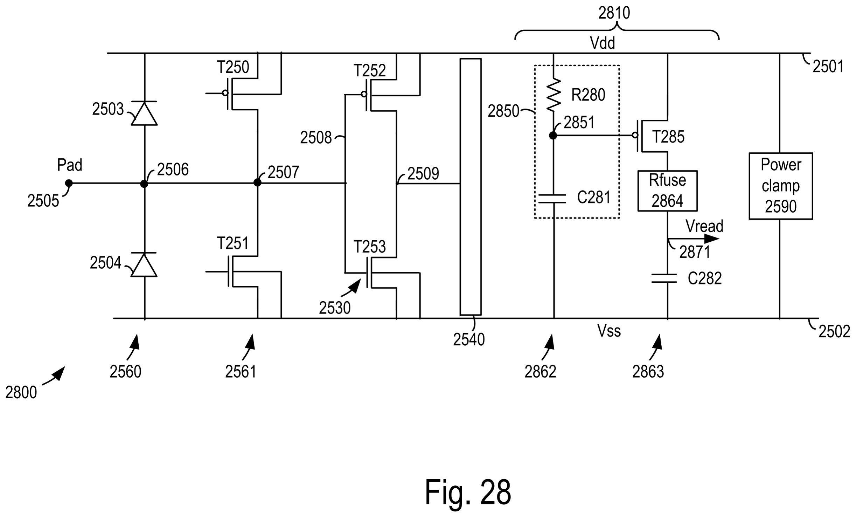

FIG. 28 depicts another example ESD circuit 2800 to detect an ESD event during die-to-die bonding, where the fuse branch 2863 of the detection circuit 2810 includes a p-type transistor T285, in accordance with various embodiments. The detection circuit includes series paths 2862 and 2863. The series path 2862 includes a resistor R280, a node 2851, and a capacitor C281 in an RC timer 2850. The series path 2863 includes a p-type transistor T285 having its gate coupled to the node 2851 between R280 and C281, a fuse 2864, Rfuse, a read node 2871, and a capacitor C282. A voltage Vread can be read out from the node 2871 to determine whether Rfuse is blown.

The circuit 2800 thus includes a p-type transistor in the fuse path (series path 2863) which can be convenient in some designs. The RC timer 2850 is designed accordingly by reversing the positions of the resistor and capacitor, compared to FIG. 25. That is, in FIG. 25, C250 is between the node 2551 and the power supply rail and R250 is between the node 2551 and the ground rail, while in FIG. 28, R280 is between the node 2851 and the power supply rail and C281 is between the node 2851 and the ground rail.

Also, in the case of FIG. 28, the fast transient component of the Vdd voltage can open the channel of T282 and let the current flow through the fuse during an ESD event.

In another example implementation, the CDM detection circuit can also be placed directly at a bump dedicated for CDM monitoring. The readout of a blown fuse can be carried out in a similar way as for the other implementations. The dedicated bumps can be placed in one location on the die or in multiple locations, e.g., in each corner.

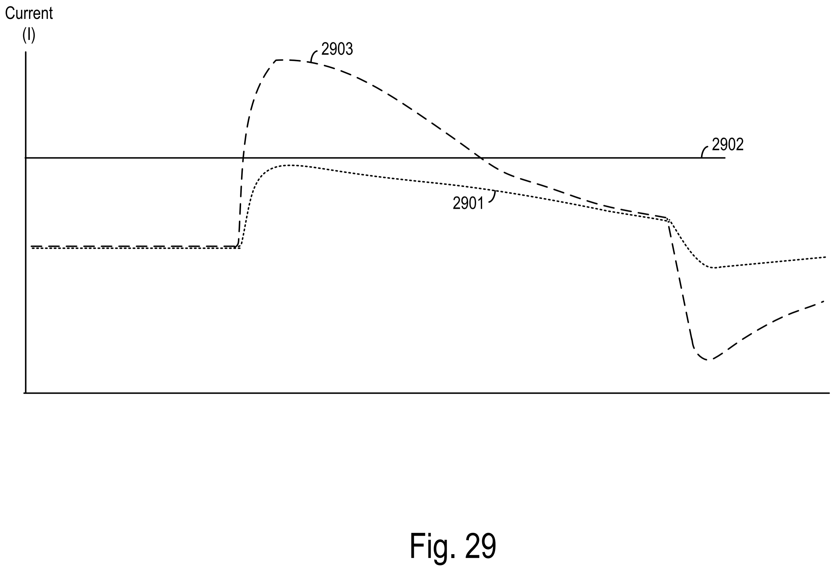

FIG. 29 depicts plots of current versus time for the fuse 2564 of FIG. 25, in accordance with various embodiments. A positive CDM current is injected into the pad 2505 and is split between the fuse path and the power clamp 2590 (FIG. 25). If the portion flowing through the fuse path exceeds a threshold value of, e.g., 50 mA (plot 2902), Rfuse is blown. The plot 2901 denotes a case where the injected CDM current is 40 mA and the threshold current in the fuse path is not exceeded, so that the fuse is not blown. The plot 2903 denotes a case where the injected CDM current is 100 mA and the threshold current in the fuse path is exceeded, so that the fuse is blown.

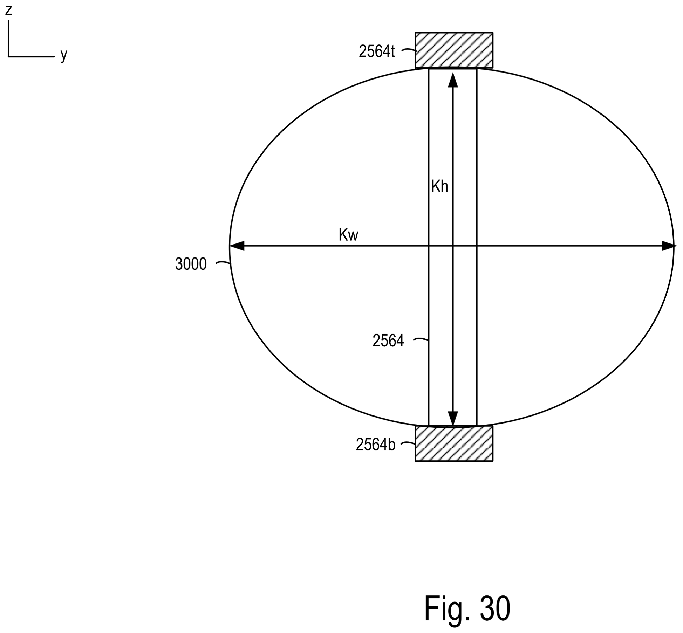

FIG. 30 depicts a diagram showing a keep-out zone 3000 for the fuse 2564 of FIG. 25 to prevent shorting with other nearby metals during overheating/filamentation, in accordance with various embodiments. The fuse 2564 is depicted in a y-z plane, where the z direction is a vertical dimension denoting an increasing height above a substrate. The fuse is elongated in the z direction, e.g., vertically-extending, and has connections 2564t and 2564b at its opposing ends, e.g., at its top and bottom respectively.

The fuse can be implemented as a thin metal line or by exploiting metal vias, for example, according to the process technology. The example corresponds to a metal via which extends in the z direction. The fuse can cause metal short circuits with other metals, e.g., other metal vias, due to overheating or filamentation caused by excessive current flow in the fuse above its capability. To protect the fuse from shorting with other metals, a keep-out zone can be created and enforced in the die design process. With this approach, the CDM current which exceeds the threshold will lead to an open circuit at the fuse without causing a short circuit with other metals such as other metal vias.

The keep-out zone 3000 can have a circular, oval or elliptical shape, for example, where the zone is widest at a half way point in the height of the fuse, and narrowest at the top and bottom of the fuse. This accounts for the fact that the fuse may potentially become more heated at mid-height than at its top and bottom. In another approach, the keep-out zone is rectangular. In one approach, the width Kw of the keep-out zone is greater than its height Kh.

In sum, the ESD detection circuit provides a number of features. First, on-die CDM detection circuit can be provided for a D2D IO connected 2.5/3D packaging process. The CDM detection circuit can include a metal fuse Rfuse which changes its resistance due to CDM discharge. For example, Rfuse can be blown after activation of a pass device that is connected in series with Rfuse. The pass device can be controlled by a high-pass filter/timer. The timer can be sensitive to slew rates of ESD discharge at the supply.

Another feature is that a Vread node between the pass device and Rfuse can be monitored by logic/-circuit that detects CDM.

A keep-out zone for the Rfuse can be defined to avoid short circuits with nearby metals during overheating or filamentation.

The CDM detection circuit can be used at supply in parallel with a multitude of D2D IOs or attached to a single bump. The D2D bump with the attached CDM detection circuit can be placed in multiple locations on a die or in a single location.

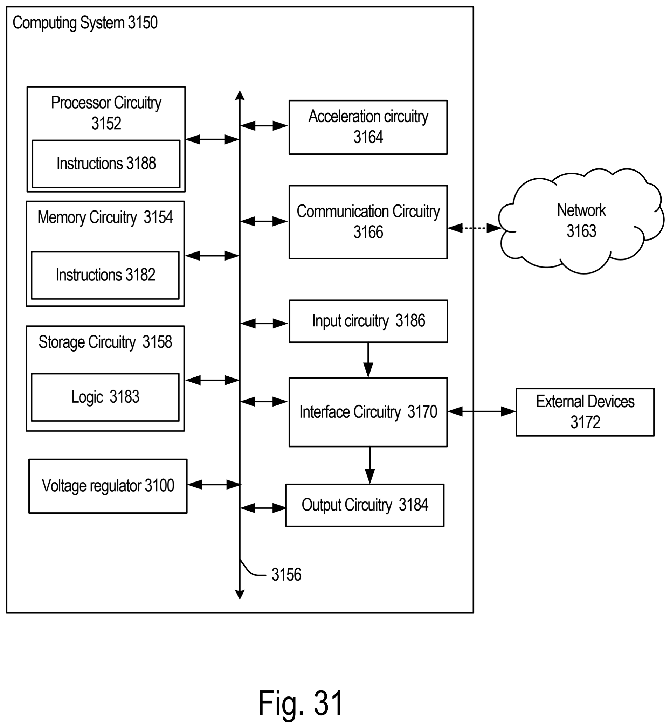

FIG. 31 illustrates an example of components that may be present in a computing system 3150 for implementing the techniques (e.g., operations, processes, methods, and methodologies) described herein.

The computing system 3150 may include any combinations of the hardware or logical components referenced herein. The components may be implemented as ICs, portions thereof, discrete electronic devices, or other modules, instruction sets, programmable logic or algorithms, hardware, hardware accelerators, software, firmware, or a combination thereof adapted in the computing system 3250, or as components otherwise incorporated within a chassis of a larger system. In an example implementation, the ESD circuit described herein is provided in one or more of the processor circuitry 3152, the memory circuitry 3154, the storage circuitry 3159, the acceleration circuitry 3164, the communication circuitry 3166, the input circuitry 3186, the interface circuitry 3170, or the output circuitry 3184.

In one approach, all or part of the computing system 3150 is provided in a SoP, System in Package (SiP) or a System on Chip (SoC).

A voltage regulator 3100 can provide a voltage Vout to one or more of the components of the computing system 3150. The memory circuitry 3154 may store instructions and the processor circuitry 3152 may execute the instructions to perform the functions described herein.

The system 3150 includes processor circuitry in the form of one or more processors 3152. The processor circuitry 3152 includes circuitry such as, but not limited to one or more processor cores and one or more of cache memory, low drop-out voltage regulators (LDOs), interrupt controllers, serial interfaces such as SPI, I2C or universal programmable serial interface circuit, real time clock (RTC), timer-counters including interval and watchdog timers, general purpose I/O, memory card controllers such as secure digital/multi-media card (SD/MMC) or similar, interfaces, mobile industry processor interface (MIPI) interfaces and Joint Test Access Group (JTAG) test access ports. In some implementations, the processor circuitry 3152 may include one or more hardware accelerators (e.g., same or similar to acceleration circuitry 3164), which may be microprocessors, programmable processing devices (e.g., FPGA, ASIC, etc.), or the like. The one or more accelerators may include, for example, computer vision and/or deep learning accelerators. In some implementations, the processor circuitry 3152 may include on-chip memory circuitry, which may include any suitable volatile and/or non-volatile memory, such as DRAM, SRAM, EPROM, EEPROM, Flash memory, solid-state memory, and/or any other type of memory device technology, such as those discussed herein.

The processor circuitry 3152 may include, for example, one or more processor cores (CPUs), application processors, GPUs, RISC processors, Acorn RISC Machine (ARM) processors, CISC processors, one or more DSPs, one or more FPGAs, one or more PLDs, one or more ASICs, one or more baseband processors, one or more radio-frequency integrated circuits (RFIC), one or more microprocessors or controllers, a multi-core processor, a multithreaded processor, an ultra-low-voltage processor, an embedded processor, or any other known processing elements, or any suitable combination thereof. The processors (or cores) 3152 may be coupled with or may include memory/storage and may be configured to execute instructions stored in the memory/storage to enable various applications or operating systems to run on the platform 3150. The processors (or cores) 3152 is configured to operate application software to provide a specific service to a user of the platform 3150. In some embodiments, the processor(s) 3152 may be a special-purpose processor(s)/controller(s) configured (or configurable) to operate according to the various embodiments herein.

As examples, the processor(s) 3152 may include an Intel® Architecture Core™ based processor such as an i3, an i5, an i7, an i9 based processor; an Intel® microcontroller-based processor such as a Quark™, an Atom™, or other MCU-based processor; Pentium® processor(s), Xeon® processor(s), or another such processor available from Intel® Corporation, Santa Clara, California. However, any number other processors may be used, such as one or more of Advanced Micro Devices (AMD) Zen® Architecture such as Ryzen® or EPYC® processor(s), Accelerated Processing Units (APUs), MxGPUs, Epyc® processor(s), or the like; A5-A12 and/or S1-S4 processor(s) from Apple® Inc., Snapdragon™ or Centriq™ processor(s) from Qualcomm® Technologies, Inc., Texas Instruments, Inc.® Open Multimedia Applications Platform (OMAP)™ processor(s); a MIPS-based design from MIPS Technologies, Inc. such as MIPS Warrior M-class, Warrior I-class, and Warrior P-class processors; an ARM-based design licensed from ARM Holdings, Ltd., such as the ARM Cortex-A, Cortex-R, and Cortex-M family of processors; the ThunderX2® provided by Cavium™, Inc.; or the like. In some implementations, the processor(s) 3152 may be a part of a system on a chip (SoC), System-in-Package (SiP), a multi-chip package (MCP), and/or the like, in which the processor(s) 3152 and other components are formed into a single integrated circuit, or a single package, such as the Edison™ or Galileo™ SoC boards from Intel® Corporation. Other examples of the processor(s) 3152 are mentioned elsewhere in the present disclosure.

The system 3150 may include or be coupled to acceleration circuitry 3164, which may be embodied by one or more AI/ML accelerators, a neural compute stick, neuromorphic hardware, an FPGA, an arrangement of GPUs, one or more SoCs (including programmable SoCs), one or more CPUs, one or more digital signal processors, dedicated ASICs (including programmable ASICs), PLDs such as complex (CPLDs) or high complexity PLDs (HCPLDs), and/or other forms of specialized processors or circuitry designed to accomplish one or more specialized tasks. These tasks may include AI/ML processing (e.g., including training, inferencing, and classification operations), visual data processing, network data processing, object detection, rule analysis, or the like. In FPGA-based implementations, the acceleration circuitry 3164 may comprise logic blocks or logic fabric and other interconnected resources that may be programmed (configured) to perform various functions, such as the procedures, methods, functions, etc. of the various embodiments discussed herein. In such implementations, the acceleration circuitry 3164 may also include memory cells (e.g., EPROM, EEPROM, flash memory, static memory (e.g., SRAM, anti-fuses, etc.) used to store logic blocks, logic fabric, data, etc. in LUTs and the like.

In some implementations, the processor circuitry 3152 and/or acceleration circuitry 3164 may include hardware elements specifically tailored for machine learning and/or artificial intelligence (AI) functionality. In these implementations, the processor circuitry 3152 and/or acceleration circuitry 3164 may be, or may include, an AI engine chip that can run many different kinds of AI instruction sets once loaded with the appropriate weightings and training code. Additionally or alternatively, the processor circuitry 3152 and/or acceleration circuitry 3164 may be, or may include, AI accelerator(s), which may be one or more of the aforementioned hardware accelerators designed for hardware acceleration of AI applications. As examples, these processor(s) or accelerators may be a cluster of artificial intelligence (AI) GPUs, tensor processing units (TPUs) developed by Google® Inc., Real AI Processors (RAPs™) provided by AlphalCs®, Nervana™ Neural Network Processors (NNPs) provided by Intel® Corp., Intel® Movidius™ Myriad'™ X Vision Processing Unit (VPU), NVIDIA® PX™ based GPUs, the NM500 chip provided by General Vision®, Hardware 3 provided by Tesla®, Inc., an Epiphany™ based processor provided by Adapteva®, or the like. In some embodiments, the processor circuitry 3152 and/or acceleration circuitry 3164 and/or hardware accelerator circuitry may be implemented as AI accelerating co-processor(s), such as the Hexagon 685 DSP provided by Qualcomm®, the PowerVR 2NX Neural Net Accelerator (NNA) provided by Imagination Technologies Limited®, the Neural Engine core within the Apple® A11 or A12 Bionic SoC, the Neural Processing Unit (NPU) within the HiSilicon Kirin provided by Huawei®, and/or the like. In some hardware-based implementations, individual subsystems of system 3150 may be operated by the respective AI accelerating coprocessor(s), AI GPUs, TPUs, or hardware accelerators (e.g., FPGAs, ASICs, DSPs, SoCs, etc.), etc., that are configured with appropriate logic blocks, bit stream(s), etc. to perform their respective functions.

The system 3150 also includes system memory 3154. Any number of memory devices may be used to provide for a given amount of system memory. As examples, the memory 3154 may be, or include, volatile memory such as random access memory (RAM), static RAM (SRAM), dynamic RAM (DRAM), synchronous DRAM (SDRAM), RAMBUS® Dynamic Random Access Memory (RDRAM®), and/or any other desired type of volatile memory device. Additionally or alternatively, the memory 3154 may be, or include, non-volatile memory such as read-only memory (ROM), erasable programmable ROM (EPROM), electrically erasable programmable (EEPROM), flash memory, non-volatile RAM, ferroelectric RAM, phase-change memory (PCM), flash memory, and/or any other desired type of non-volatile memory device. Access to the memory 3154 is controlled by a memory controller. The individual memory devices may be of any number of different package types such as single die package (SDP), dual die package (DDP) or quad die package (Q17P). Any number of other memory implementations may be used, such as dual inline memory modules (DIMMs) of different varieties including but not limited to microDIMMs or MiniDIMMs.

Storage circuitry 3158 provides persistent storage of information such as data, applications, operating systems and so forth. In an example, the storage 3158 may be implemented via a solid-state disk drive (SSDD) and/or high-speed electrically erasable memory (commonly referred to as "flash memory"). Other devices that may be used for the storage 3158 include flash memory cards, such as SD cards, microSD cards, XD picture cards, and the like, and USB flash drives. In an example, the memory device may be or may include memory devices that use chalcogenide glass, multi-threshold level NAND flash memory, NOR flash memory, single or multi-level Phase Change Memory (PCM), a resistive memory, nanowire memory, ferroelectric transistor random access memory (FeTRAM), anti-ferroelectric memory, magnetoresistive random access memory (MRAM) memory that incorporates memristor technology, phase change RAM (PRAM), resistive memory including the metal oxide base, the oxygen vacancy base and the conductive bridge Random Access Memory (CB-RAM), or spin transfer torque (STT)-MRAM, a spintronic magnetic junction memory based device, a magnetic tunneling junction (MTJ) based device, a Domain Wall (DW) and Spin Orbit Transfer (SOT) based device, a thyristor based memory device, a hard disk drive (HDD), micro HDD, of a combination thereof, and/or any other memory. The memory circuitry 3154 and/or storage circuitry 3158 may also incorporate three-dimensional (3D) cross-point (XPOINT) memories from Intel® and Micron®.

The memory circuitry 3154 and/or storage circuitry 3158 is/are configured to store computational logic 3183 in the form of software, firmware, microcode, or hardware-level instructions to implement the techniques described herein. The computational logic 3183 may be employed to store working copies and/or permanent copies of programming instructions, or data to create the programming instructions, for the operation of various components of system 3150 (e.g., drivers, libraries, application programming interfaces (APIs), etc.), an operating system of system 3150, one or more applications, and/or for carrying out the embodiments discussed herein. The computational logic 3183 may be stored or loaded into memory circuitry 3154 as instructions 3182, or data to create the instructions 3182, which are then accessed for execution by the processor circuitry 3152 to carry out the functions described herein. The processor circuitry 3152 and/or the acceleration circuitry 3164 accesses the memory circuitry 3154 and/or the storage circuitry 3158 over the interconnect (IX) 3156. The instructions 3182 direct the processor circuitry 3152 to perform a specific sequence or flow of actions, for example, as described with respect to flowchart(s) and block diagram(s) of operations and functionality depicted previously. The various elements may be implemented by assembler instructions supported by processor circuitry 3152 or high-level languages that may be compiled into instructions 3188, or data to create the instructions 3188, to be executed by the processor circuitry 3152. The permanent copy of the programming instructions may be placed into persistent storage devices of storage circuitry 3158 in the factory or in the field through, for example, a distribution medium (not shown), through a communication interface (e.g., from a distribution server (not shown)), over-the-air (OTA), or any combination thereof.

The IX 3156 couples the processor 3152 to communication circuitry 3166 for communications with other devices, such as a remote server (not shown) and the like. The communication circuitry 3166 is a hardware element, or collection of hardware elements, used to communicate over one or more networks 3163 and/or with other devices. In one example, communication circuitry 3166 is, or includes, transceiver circuitry configured to enable wireless communications using any number of frequencies and protocols such as, for example, the Institute of Electrical and Electronics Engineers (IEEE) 802.11 (and/or variants thereof), IEEE 802.23.4, Bluetooth® and/or Bluetooth® low energy (BLE), ZigBee®, LoRaWAN™ (Long Range Wide Area Network), a cellular protocol such as 3GPP LTE and/or Fifth Generation (5G)/New Radio (NR), and/or the like. Additionally, or alternatively, communication circuitry 3166 is, or includes, one or more network interface controllers (NICs) to enable wired communication using, for example, an Ethernet connection, Controller Area Network (CAN), Local Interconnect Network (LIN), DeviceNet, ControlNet, Data Highway+, or PROFINET, among many others.

The IX 3156 also couples the processor 3152 to interface circuitry 3170 that is used to connect system 3150 with one or more external devices 3172. The external devices 3172 may include, for example, sensors, actuators, positioning circuitry (e.g., global navigation satellite system (GNSS)/Global Positioning System (GPS) circuitry), client devices, servers, network appliances (e.g., switches, hubs, routers, etc.), integrated photonics devices (e.g., optical neural network (ONN) integrated circuit (IC) and/or the like), and/or other like devices.

In some optional examples, various input/output (I/O) devices may be present within or connected to, the system 3150, which are referred to as input circuitry 3186 and output circuitry 3184. The input circuitry 3186 and output circuitry 3184 include one or more user interfaces designed to enable user interaction with the platform 3150 and/or peripheral component interfaces designed to enable peripheral component interaction with the platform 3150. Input circuitry 3186 may include any physical or virtual means for accepting an input including, inter alia, one or more physical or virtual buttons (e.g., a reset button), a physical keyboard, keypad, mouse, touchpad, touchscreen, microphones, scanner, headset, and/or the like. The output circuitry 3184 may be included to show information or otherwise convey information, such as sensor readings, actuator position(s), or other like information. Data and/or graphics may be displayed on one or more user interface components of the output circuitry 3184. Output circuitry 3184 may include any number and/or combinations of audio or visual display, including, inter alia, one or more simple visual outputs/indicators (e.g., binary status indicators (e.g., light emitting diodes (LEDs)) and multi-character visual outputs, or more complex outputs such as display devices or touchscreens (e.g., Liquid Crystal Displays (LCD), LED displays, quantum dot displays, projectors, etc.), with the output of characters, graphics, multimedia objects, and the like being generated or produced from the operation of the platform 3150. The output circuitry 3184 may also include speakers and/or other audio emitting devices, printer(s), and/or the like. Additionally, or alternatively, sensor(s) may be used as the input circuitry 3184 (e.g., an image capture device, motion capture device, or the like) and one or more actuators may be used as the output device circuitry 3184 (e.g., an actuator to provide haptic feedback or the like). Peripheral component interfaces may include, but are not limited to, a non-volatile memory port, a USB port, an audio jack, a power supply interface, etc. In some embodiments, a display or console hardware, in the context of the present system, may be used to provide output and receive input of an edge computing system; to manage components or services of an edge computing system; identify a state of an edge computing component or service; or to conduct any other number of management or administration functions or service use cases.

The components of the system 3150 may communicate over the IX 3156. The IX 3156 may include any number of technologies, including ISA, extended ISA, I2C, SPI, point-to-point interfaces, power management bus (PMBus), PCI, PCIe, PCIx, Intel® UPI, Intel® Accelerator Link, Intel® CXL, CAPI, OpenCAPI, Intel® QPI, UPI, Intel® OPA IX, RapidIO™ system IXs, CCIX, Gen-Z Consortium IXs, a HyperTransport interconnect, NVLink provided by NVIDIA®, a Time-Trigger Protocol (TTP) system, a FlexRay system, PROFIBUS, and/or any number of other IX technologies. The IX 3156 may be a proprietary bus, for example, used in a SoC based system.

The number, capability, and/or capacity of the elements of system 3150 may vary, depending on whether computing system 3150 is used as a stationary computing device (e.g., a server computer in a data center, a workstation, a desktop computer, etc.) or a mobile computing device (e.g., a smartphone, tablet computing device, laptop computer, game console, IoT device, etc.). In various implementations, the computing device system 3150 may comprise one or more components of a data center, a desktop computer, a workstation, a laptop, a smartphone, a tablet, a digital camera, a smart appliance, a smart home hub, a network appliance, and/or any other device/system that processes data.

The techniques described herein can be performed partially or wholly by software or other instructions provided in a machine-readable storage medium (e.g., memory). The software is stored as processor-executable instructions (e.g., instructions to implement any other processes discussed herein). Instructions associated with the flowchart (and/or various embodiments) and executed to implement embodiments of the disclosed subject matter may be implemented as part of an operating system or a specific application, component, program, object, module, routine, or other sequence of instructions or organization of sequences of instructions.

The storage medium can be a tangible, non-transitory machine readable medium such as read only memory (ROM), random access memory (RAM), flash memory devices, floppy and other removable disks, magnetic storage media, optical storage media (e.g., Compact Disk Read-Only Memory (CD ROMS), Digital Versatile Disks (DVDs)), among others.

The storage medium may be included, e.g., in a communication device, a computing device, a network device, a personal digital assistant, a manufacturing tool, a mobile communication device, a cellular phone, a notebook computer, a tablet, a game console, a set top box, an embedded system, a TV (television), or a personal desktop computer.

Some non-limiting examples of various embodiments are presented below.

Example 1 includes an apparatus, comprising: an input/output rail; a ground rail; at least one of a receiver or a transmitter coupled to the input/output rail; and a circuit coupled to the input/output rail and the ground rail, wherein the circuit comprises one or more discharge paths including one or more bulk-less transistors.

Example 2 includes the apparatus of Example 1, wherein the one or more discharge paths comprise discharge paths of first and second stages.

Example 3 includes the apparatus of Example 1 or 2, wherein the one or more discharge paths comprises a discharge path for an overvoltage electrostatic discharge (ESD) event and a discharge path for an undervoltage ESD event.

Example 4 includes the apparatus of Example 3, wherein the one or more discharge paths comprises discharge paths of first and second stages for the overvoltage ESD event and discharge paths of first and second stages for the undervoltage ESD event.

Example 5 includes the apparatus of any one of Examples 1-4, wherein the one or more bulk-less transistors comprise gate-all-around (GAA) transistors.

Example 6 includes the apparatus of any one of Examples 1-5, wherein the one or more discharge paths comprise one or more diodes in series with a first transistor, and the circuit further comprises an inverter coupled to a gate of the first transistor, a first resistor-capacitor (RC) timer coupled to an input of the inverter, a second transistor coupled between the input of the inverter and the ground rail, and a second RC timer coupled to a gate of the second transistor.

Example 7 includes the apparatus of any one of Examples 1-6, wherein the one or more discharge paths comprise one or more diodes in series with a first transistor, and the circuit further comprises a first inverter coupled to a gate of the first transistor, a second inverter coupled to the first inverter, a first resistor-capacitor (RC) timer coupled to an input of the second inverter, a second transistor coupled between the input of the second inverter and the ground rail, and a second RC timer coupled to a gate of the second transistor.

Example 8 includes the apparatus of any one of Examples 1-7, further comprising a ballast in series with the input/output rail, between the circuit and the at least one of a receiver or a transmitter.

Example 9 includes the apparatus of any one of Examples 1-8, wherein the apparatus is provided in at least one of an integrated circuit, a System on Chip, a System in Package or a computing device.

Example 10 includes an apparatus, comprising: a power supply rail; a ground rail; an input/output pad; at least one of a receiver or a transmitter coupled to the power supply rail, the ground rail and the input/output pad; and a discharge path coupled between the power supply rail and the ground rail, and to the input/output pad, wherein the discharge path includes one or more bulk-less transistors.

Example 11 includes the apparatus of Example 10, wherein the one or more bulk-less transistors comprise a p-type transistor and an n-type transistor, and the apparatus further comprises a high-impedance device coupled to the input/output pad and to a node between the p-type transistor and the n-type transistor.

Example 12 includes the apparatus of Example 10 or 11, wherein the one or more bulk-less transistors comprise a p-type transistor and an n-type transistor, and the apparatus further comprises gate control circuits coupled to gates of the p-type transistor and the n-type transistor.

Example 13 includes the apparatus of any one of Examples 10-12, wherein the one or more bulk-less transistors comprise a p-type transistor and an n-type transistor, a gate of the p-type transistor is coupled to the power supply rail and a gate of the n-type transistor is coupled to the ground rail.

Example 14 includes the apparatus of any one of Examples 10-13, wherein the one or more bulk-less transistors comprise a p-type transistor and an n-type transistor, and the apparatus further comprises a first resistor-capacitor (RC) timer coupled to a gate of the p-type transistor and a second RC timer coupled to the gate of the n-type transistor.

Example 15 includes the apparatus of any one of Examples 10-14, further comprising a series path coupled between the power supply rail and the ground rail, and to the input/output pad, wherein the series path comprises first and second diodes, and the apparatus further comprises an inductor coupled to the input/output pad and to a node between the first and second diodes.

Example 16 includes the apparatus of any one of Examples 10-15, further comprising a shutdown circuit coupled to the one or more bulk-less transistors, wherein the shutdown circuit comprises a first shutdown voltage node, a second shutdown voltage node, and one or more transistors in a source-follower configuration between the first and second shutdown voltage nodes.

Example 17 includes an apparatus, comprising: a power supply rail; a ground rail; one or more input/output circuits coupled to the power supply rail and the ground rail; and an electrostatic discharge (ESD) detection circuit coupled between the power supply rail and the ground rail, wherein the ESD detection circuit comprises a path between the power supply rail and the ground rail, and the path comprises a fuse and a read node.

Example 18 includes the apparatus of Example 17, wherein the fuse is configured to rupture during an ESD event, and a voltage at the read node is based on whether the fuse has ruptured.

Example 19 includes the apparatus of Example 17 or 18, wherein the path is a first path, and the ESD detection circuit further comprises a second path coupled between the power supply rail and the ground rail, wherein the second path includes a fuse and a read node, and the fuse of the second path has a different size than the fuse of the first path.

Example 20 includes the apparatus of any one of Examples 17-19, wherein the one or more input/output circuits comprises a set of input/output circuits in parallel with a single ESD detection circuit.

Example 21 includes a method, comprising: receiving and/or transmitting a signal on an input/output rail via at least one of a transmitter or a receiver; and turning on one or more bulk-less transistors in a discharge path between the input/output rail and a ground rail during an electrostatic discharge (ESD) overvoltage and/or undervoltage at the input/output rail.

Example 22 includes an apparatus, comprising means to perform the method of Example 21.

Example 23 includes a machine-readable storage including machine-readable instructions which, when executed, cause a computer to implement the method of Example 21.

Example 24 includes a computer program comprising instructions which, when executed by a computer, cause the computer to carry out the method of Example 21.

Example 25 includes a method, comprising: receiving and/or transmitting a signal on an input/output pad via at least one of a transmitter or a receiver, wherein the at least one of a transmitter or a receiver is coupled to a power supply rail and a ground rail; and turning on one or more bulk-less transistors in a discharge path between the power supply rail and the ground rail during an electrostatic discharge (ESD) overvoltage and/or undervoltage at the power supply rail.

Example 26 includes an apparatus, comprising means to perform the method of Example 25.

Example 27 includes a machine-readable storage including machine-readable instructions which, when executed, cause a computer to implement the method of Example 25.

Example 28 includes a computer program comprising instructions which, when executed by a computer, cause the computer to carry out the method of Example 25.

Example 29 includes a method, comprising: receiving a shutdown voltage at an electrostatic discharge (ESD) shutdown circuit; dropping the shutdown voltage from a second voltage to a first voltage; and turning on a transistor in a discharge path between a power supply rail and a ground rail based on the first voltage.

Example 30 includes an apparatus, comprising means to perform the method of Example 29.

Example 31 includes a machine-readable storage including machine-readable instructions which, when executed, cause a computer to implement the method of Example 29.

Example 32 includes a computer program comprising instructions which, when executed by a computer, cause the computer to carry out the method of Example 29.

Example 33 includes a method, comprising: reading a voltage from a read node in a path between a power supply rail and a ground rail, wherein the path comprises a fuse; and determining whether an electrostatic discharge (ESD) event has occurred based on the voltage, wherein one or more input/output circuits are coupled to the power supply rail and the ground rail.

Example 34 includes an apparatus, comprising means to perform the method of Example 33.

Example 35 includes a machine-readable storage including machine-readable instructions which, when executed, cause a computer to implement the method of Example 33.

Example 36 includes a computer program comprising instructions which, when executed by a computer, cause the computer to carry out the method of Example 33.

Various operations may be described as multiple discrete actions or operations in turn, in a manner that is most helpful in understanding the claimed subject matter. However, the order of description should not be construed as to imply that these operations are necessarily order dependent. In particular, these operations may not be performed in the order of presentation. Operations described may be performed in a different order than the described embodiment. Various additional operations may be performed and/or described operations may be omitted in additional embodiments.

The terms "substantially," "close," "approximately," "near," and "about," generally refer to being within +/- 10% of a target value. Unless otherwise specified the use of the ordinal adjectives "first," "second," and "third," etc., to describe a common object, merely indicate that different instances of like objects are being referred to, and are not intended to imply that the objects so described must be in a given sequence, either temporally, spatially, in ranking or in any other manner.

For the purposes of the present disclosure, the phrases "A and/or B" and "A or B" mean (A), (B), or (A and B). For the purposes of the present disclosure, the phrase "A, B, and/or C" means (A), (B), (C), (A and B), (A and C), (B and C), or (A, B, and C).

The description may use the phrases "in an embodiment," or "in embodiments," which may each refer to one or more of the same or different embodiments. Furthermore, the terms "comprising," "including," "having," and the like, as used with respect to embodiments of the present disclosure, are synonymous.

As used herein, the term "circuitry" may refer to, be part of, or include an Application Specific Integrated Circuit (ASIC), an electronic circuit, a processor (shared, dedicated, or group), a combinational logic circuit, and/or other suitable hardware components that provide the described functionality. As used herein, "computer-implemented method" may refer to any method executed by one or more processors, a computer system having one or more processors, a mobile device such as a smartphone (which may include one or more processors), a tablet, a laptop computer, a set-top box, a gaming console, and so forth.

The terms "coupled," "communicatively coupled," along with derivatives thereof are used herein. The term "coupled" may mean two or more elements are in direct physical or electrical contact with one another, may mean that two or more elements indirectly contact each other but still cooperate or interact with each other, and/or may mean that one or more other elements are coupled or connected between the elements that are said to be coupled with each other. The term "directly coupled" may mean that two or more elements are in direct contact with one another. The term "communicatively coupled" may mean that two or more elements may be in contact with one another by a means of communication including through a wire or other interconnect connection, through a wireless communication channel or link, and/or the like.

Reference in the specification to "an embodiment," "one embodiment," "some embodiments," or "other embodiments" means that a particular feature, structure, or characteristic described in connection with the embodiments is included in at least some embodiments, but not necessarily all embodiments. The various appearances of "an embodiment," "one embodiment," or "some embodiments" are not necessarily all referring to the same embodiments. If the specification states a component, feature, structure, or characteristic "may," "might," or "could" be included, that particular component, feature, structure, or characteristic is not required to be included. If the specification or claim refers to "a" or "an" element, that does not mean there is only one of the elements. If the specification or claims refer to "an additional" element, that does not preclude there being more than one of the additional elements.

Furthermore, the particular features, structures, functions, or characteristics may be combined in any suitable manner in one or more embodiments. For example, a first embodiment may be combined with a second embodiment anywhere the particular features, structures, functions, or characteristics associated with the two embodiments are not mutually exclusive.

While the disclosure has been described in conjunction with specific embodiments thereof, many alternatives, modifications and variations of such embodiments will be apparent to those of ordinary skill in the art in light of the foregoing description. The embodiments of the disclosure are intended to embrace all such alternatives, modifications, and variations as to fall within the broad scope of the appended claims.

In addition, well-known power/ground connections to integrated circuit (IC) chips and other components may or may not be shown within the presented figures, for simplicity of illustration and discussion, and so as not to obscure the disclosure. Further, arrangements may be shown in block diagram form in order to avoid obscuring the disclosure, and also in view of the fact that specifics with respect to implementation of such block diagram arrangements are highly dependent upon the platform within which the present disclosure is to be implemented (i.e., such specifics should be well within purview of one skilled in the art). Where specific details (e.g., circuits) are set forth in order to describe example embodiments of the disclosure, it should be apparent to one skilled in the art that the disclosure can be practiced without, or with variation of, these specific details. The description is thus to be regarded as illustrative instead of limiting.

An abstract is provided that will allow the reader to ascertain the nature and gist of the technical disclosure. The abstract is submitted with the understanding that it will not be used to limit the scope or meaning of the claims. The following claims are hereby incorporated into the detailed description, with each claim standing on its own as a separate embodiment.

## Claims

1. An apparatus, comprising:

   an input/output rail;
   a ground rail;
   at least one of a receiver or a transmitter coupled to the input/output rail; and
   a circuit coupled to the input/output rail and the ground rail, wherein the circuit comprises one or more discharge paths including one or more bulk-less transistors.

2. The apparatus of claim 1, wherein the one or more discharge paths comprise discharge paths of first and second stages.

3. The apparatus of claim 1 or 2, wherein the one or more discharge paths comprise a discharge path for an overvoltage electrostatic discharge, ESD, event and a discharge path for an undervoltage ESD event.

4. The apparatus of claim 3, wherein the one or more discharge paths comprise discharge paths of first and second stages for the overvoltage ESD event and discharge paths of first and second stages for the undervoltage ESD event.

5. The apparatus of any one of claims 1-4, wherein the one or more bulk-less transistors comprise gate-all-around, GAA, transistors.

6. The apparatus of any one of claims 1-5, wherein the one or more discharge paths comprise one or more diodes in series with a first transistor, and the circuit further comprises an inverter coupled to a gate of the first transistor, a first resistor-capacitor, RC, timer coupled to an input of the inverter, a second transistor coupled between the input of the inverter and the ground rail, and a second RC timer coupled to a gate of the second transistor.

7. The apparatus of any one of claims 1-6, wherein the one or more discharge paths comprise one or more diodes in series with a first transistor, and the circuit further comprises a first inverter coupled to a gate of the first transistor, a second inverter coupled to the first inverter, a first resistor-capacitor, RC, timer coupled to an input of the second inverter, a second transistor coupled between the input of the second inverter and the ground rail, and a second RC timer coupled to a gate of the second transistor.

8. The apparatus of any one of claims 1-7, further comprising a ballast in series with the input/output rail, between the circuit and the at least one of a receiver or a transmitter.

9. The apparatus of any one of claims 1-8, wherein the apparatus is provided in at least one of an integrated circuit, a System on Chip, a System in Package or a computing device.

10. A method, comprising:

    receiving and/or transmitting a signal on an input/output pad via at least one of a transmitter or a receiver, wherein the at least one of a transmitter or a receiver is coupled to a power supply rail and a ground rail; and
    turning on one or more bulk-less transistors in one or more discharge paths between the power supply rail and the ground rail during an electrostatic discharge, ESD, overvoltage and/or undervoltage at the power supply rail.

11. The method of claim 10, wherein the one or more discharge paths comprise discharge paths of first and second stages.

12. The method of claim 10 or 11, further comprising:

    reading a voltage from a read node in a path between the power supply rail and the ground rail, wherein the path comprises a fuse; and determining whether the ESD event has occurred based on the voltage.

13. The method of any one of claims 10-12, further comprising:

receiving a shutdown voltage; dropping the shutdown voltage from a second voltage to a first voltage; and turning on the one or more bulk-less transistors based on the first voltage.

14. An apparatus, comprising means to perform any one of claims 10-12.

15. A machine-readable storage including machine-readable instructions which, when executed, cause a computer to implement the method of any one of claims 10-12.

Fig. 1

100

Fig. 2

Fig. 3B

Fig. 3A

**Fig. 4A**

**Fig. 4B**

Fig. 5

Fig. 6

EP 4 766 093 A1

Fig. 7

EP 4 766 093 A1

Current
(I)

Voltage
(V)

820 (V)

810 (V)

800 (I)

Fig. 8

Fig. 9

Fig. 10

EP 4 766 093 A1

Fig. 11

Fig. 12

EP 4 766 093 A1

Fig. 13

Fig. 14

EP 4 766 093 A1

Fig. 15

EP 4 766 093 A1

Fig. 16

EP 4 766 093 A1

Fig. 17

Fig. 18

EP 4 766 093 A1

Vdd_esd
1901

Vsd 1905 →  Disable circuit 1910  → 1903 →  RC-triggered ESD clamp 1920

Vss_esd
1902

1900 ↗

**Fig. 19**

Vdd_esd
1901

Vsd3 2012 →
Vsd2 2011 →  2015 {  Disable circuit 2005  → 1901 →  RC-triggered ESD clamp 1920
Vsd1 2010 →

Vss_esd
1902

2000 ↗

**Fig. 20**

Fig. 21A

Fig. 21B

EP 4 766 093 A1

Fig. 22

Fig. 23

Fig. 24

EP 4 766 093 A1

Fig. 25

Fig. 26

Fig. 27

EP 4 766 093 A1

Fig. 28

EP 4 766 093 A1

Current
(I)

2902

2903

2901

Fig. 29

Fig. 30

EP 4 766 093 A1

Computing System 3150

Processor Circuitry 3152

Instructions 3188

Memory Circuitry 3154

Instructions 3182

Storage Circuitry 3158

Logic 3183

Voltage regulator 3100

Acceleration circuitry 3164

Communication Circuitry 3166

Network 3163

Input circuitry 3186

Interface Circuitry 3170

External Devices 3172

Output Circuitry 3184

3156

Fig. 31

Europäisches
Patentamt

European
Patent Office

Office européen
des brevets

# EUROPEAN SEARCH REPORT

**Application Number**

EP 25 21 2086

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | DE 10 2020 132568 A1 (TAIWAN SEMICONDUCTOR MFG CO LTD [TW]) 30 September 2021 (2021-09-30) * abstract; figures 1A,1B, 5A-5C * * paragraphs [0014], [0049] * | 1-15 | INV. H10D89/60 |
| X | US 2021/167180 A1 (KAR AYAN [US] ET AL) 3 June 2021 (2021-06-03) | 1,5,9, 10,14,15 | |
| A | * abstract; figures 8, 9 * * paragraphs [0003], [0033], [0076] – [0078] * | 2-4,6-8, 11-13 | |
| X | US 2024/332181 A1 (KANG TSUNG-SHENG [US] ET AL) 3 October 2024 (2024-10-03) | 10,14 | |
| A | * the whole document * | 1-9, 11-13,15 | |
| A | US 2013/215541 A1 (KARP JAMES [US]) 22 August 2013 (2013-08-22) * abstract; figures 1-3 * | 1,6,7 | |
| A | US 2002/153570 A1 (LIN GEENG-LIH [TW] ET AL) 24 October 2002 (2002-10-24) * abstract; figures 1-3 * | 1,2,4,8 | TECHNICAL FIELDS SEARCHED (IPC) H10D H02H |

The present search report has been drawn up for all claims

| Place of search | Date of completion of the search | Examiner |
|---|---|---|
| Berlin | 9 April 2026 | Morena, Enrico |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 25 21 2086

This annex lists the patent family members relating to the patent documents cited in the above-mentioned European search report.
The members are as contained in the European Patent Office EDP file on
The European Patent Office is in no way liable for these particulars which are merely given for the purpose of information.

09-04-2026

| Patent document cited in search report | Publication date | Patent family member(s) | Publication date |
|---|---|---|---|
| DE 102020132568 A1 | 30-09-2021 | CN 113054636 A<br>DE 102020132568 A1<br>KR 20210122666 A<br>TW 202139415 A<br>US 2025330013 A1 | 29-06-2021<br>30-09-2021<br>12-10-2021<br>16-10-2021<br>23-10-2025 |
| US 2021167180 A1 | 03-06-2021 | CN 112885902 A<br>US 2021167180 A1 | 01-06-2021<br>03-06-2021 |
| US 2024332181 A1 | 03-10-2024 | NONE | |
| US 2013215541 A1 | 22-08-2013 | US 2013215541 A1<br>WO 2013126102 A1 | 22-08-2013<br>29-08-2013 |
| US 2002153570 A1 | 24-10-2002 | TW 488056 B<br>US 2002153570 A1 | 21-05-2002<br>24-10-2002 |

For more details about this annex : see Official Journal of the European Patent Office, No. 12/82